# EUROPEAN PATENT APPLICATION

(11) **EP 4 826 450 A1**
(43) Date of publication of application: **21.10.2026**
(21) Application number: 26170815.0
(22) Date of filing: 07.04.2026
(51) Int. Cl.: G03F 7/09

(54) **COMPOSITION FOR FORMING PROTECTIVE FILM, SUBSTRATE FOR MANUFACTURING SEMICONDUCTOR DEVICE, METHOD FOR FORMING PROTECTIVE FILM, AND PATTERNING PROCESS**

(30) Priority: 16.04.2025 JP 2025067263
(71) Applicant: SHIN-ETSU CHEMICAL CO., LTD., Tokyo 100-0005 (JP)
(72) Inventor: Niida, Keisuke, Niigata (JP); Nakahara, Takayoshi, Niigata (JP); Kori, Daisuke, Niigata (JP)
(74) Representative: Schicker, Silvia

(57) **Abstract**

The present invention is a composition for forming a protective film against an alkaline aqueous hydrogen peroxide, the composition containing: (A1) a polymer having a repeating unit represented by the following general formula (1A) and having a group represented by the following general formula (1B) as a terminal group; and (B) an organic solvent, where W₁ represents a sulfinyl group, a sulfonyl group, an ether group, or a divalent organic group having 2 to 50 carbon atoms, and W₂ represents a divalent organic group having 2 to 50 carbon atoms. This can provide a composition for forming a protective film against an alkaline aqueous hydrogen peroxide, the protective film being capable of exhibiting excellent resistance to an alkaline aqueous hydrogen peroxide, favorable filling and planarizing properties, and excellent dry etching properties.

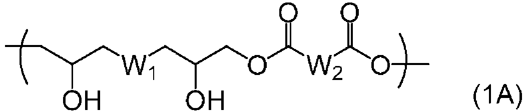

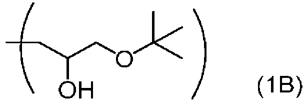

## Description

### TECHNICAL FIELD

The present invention relates to: a composition for forming a protective film that provides a protective film that exhibits resistance to wet-etching liquid (in particular, alkaline aqueous hydrogen peroxide) used in a semiconductor device manufacturing process; a substrate for manufacturing a semiconductor device, the substrate including a cured product of the composition; a method for forming a protective film; and a patterning process according to a multilayer resist method.

### BACKGROUND ART

Conventionally, higher integration and higher processing speed of semiconductor devices have been achieved by miniaturization of pattern size by shortening the wavelength of a light source in lithography technology using light exposure (photolithography) as a widely used technique. To form such a fine circuit pattern on a semiconductor device substrate (substrate to be processed), generally, a method of processing a substrate to be processed by dry etching while using a photoresist film having a formed pattern as an etching mask is used. In practice, however, there is no dry etching method capable of providing an absolute etching selectivity between the photoresist film and the substrate to be processed, and therefore, in recent years, substrate processing according to a multilayer resist method has become common. This method is as follows: a middle layer film having a different etching selectivity from a photoresist film (hereinafter, a resist upper layer film) is placed between the resist upper layer film and a substrate to be processed; a pattern is formed in the resist upper layer film; then, the pattern is transferred to the middle layer film by dry etching while using the resist upper layer film pattern as a dry etching mask; and the pattern is further transferred to the substrate to be processed by dry etching while using the middle layer film as a dry etching mask.

One of the multilayer resist methods is a 3-layer resist method, which can be performed with a typical resist composition used in the monolayer resist method. This method includes the following steps: an organic underlayer film (hereinafter, an organic film) is formed by applying and baking an organic underlayer film material, containing an organic resin-containing composition, onto a substrate to be processed; a silicon-containing film (hereinafter, a silicon middle layer film) is formed thereon by applying and baking a resist middle layer film material, containing a composition containing a silicon-containing resin; and a common organic photoresist film (hereinafter, a resist upper layer film) is formed thereon. When dry etching is performed with fluorine-based gas plasma after patterning the resist upper layer film, the organic resist upper layer film exhibits a favorable etching selectivity ratio relative to the silicon middle layer film, and therefore, the resist upper layer film pattern can be transferred to the silicon middle layer film. According to this process, even when using a resist upper layer film that does not have a sufficient film thickness for directly processing the substrate to be processed or a resist upper layer film that does not have sufficient dry-etching resistance for processing the substrate to be processed, a silicon middle layer film usually has a film thickness equivalent to or less than that of a resist upper layer film, and therefore, a pattern can be transferred to the silicon middle layer film easily. By subsequently transferring the pattern to the organic underlayer film by dry etching using an oxygen- or hydrogen-based gas plasma while using the silicon middle layer film having the transferred pattern as a dry-etching mask, it is possible to transfer the pattern to an organic underlayer film having sufficient dry-etching resistance for processing the substrate. Using this organic underlayer film pattern, having the transferred pattern, the pattern can be transferred to the substrate by dry etching using a fluorine-based gas, a chlorine-based gas, etc.

Meanwhile, miniaturization in the manufacturing process of semiconductor devices is approaching the fundamental limit that comes from the wavelength of the light source for photolithography. Therefore, in recent years, means for achieving higher integration of semiconductor devices without depending on miniaturization are being studied. As one such means, semiconductor devices having complicated structures, such as a multigate structure, are being studied, and some have already been put to practical use. When such a structure is formed by a multilayer resist method, it is possible to apply an organic film material that can fill, with a film without gaps, a fine pattern, such as holes, trenches, and fins, formed on a substrate to be processed, or fill steps or pattern-dense portions and no-pattern regions with a film so as to perform planarization. By forming a flat organic underlayer film surface on a stepped substrate by using such an organic film material, it is possible to suppress fluctuation in the film thickness of a silicon middle layer film and resist upper layer film formed thereon, and suppress degradation in a focus margin in photolithography and a margin in a subsequent step of processing the substrate to be processed. In addition, to remove the resist underlayer film used for filling and planarization by dry etching without residues after the substrate processing, a resist underlayer film having dry-etching properties different from those described above, for example, a resist underlayer film having a dry-etching rate higher than that of the resist upper layer film is required in some cases. Furthermore, substrate processing by wet etching using a chemical is required in some cases, and in that case, the resist underlayer film to be a processing mask is also required to have resistance to wet-etching liquid.

Here, background of desire for a material usable in the wet etching process in the multilayer resist method will be described in detail. To improve performance of the semiconductor device, the most advanced semiconductor device uses technologies such as three-dimensional transistor and through wiring. In a patterning step used for forming structures in such a semiconductor device, the patterning by the above multilayer resist method is performed. Such patterning may require, after the pattern formation, a step of removing the silicon middle layer film without damaging the pattern. If this removal is insufficient, that is, if the wafer is subjected to the next production process with remained an object to be washed, the yield of the device production is certainly decreased. As described above, cleanness degree required in the washing step has been increased as the devices have been miniaturized. However, both a major constituting element in the conventional silicon middle layer film and a major constituting element in the conventional semiconductor device substrate are often silicon. When an attempt is made to selectively remove the silicon middle layer film by dry etching, it is difficult to suppress damage to the semiconductor device substrate because the major constituting element of the semiconductor device substrate is similar to that of the silicon middle layer film. This problem cannot be solved by wet etching using a common hydrofluoric acid-based removing liquid. Hence, as a removing liquid that does not damage the semiconductor device substrate, considered is application of an alkaline aqueous hydrogen peroxide called SC1 (Standard Clean-1), which is commonly used in the semiconductor manufacturing process, as the wet-etching liquid. In this case, the organic underlayer film is conversely required to exhibit resistance to the alkaline aqueous hydrogen peroxide.

In addition, considered is a process of wet-etching a substrate to be processed, such as titanium nitride, by using an alkaline aqueous hydrogen peroxide while using an organic underlayer film as an etching mask. The organic underlayer film is required to have resistance to the alkaline aqueous hydrogen peroxide in this case as well.

As a resist underlayer film material for manufacturing a semiconductor device, the material having favorable resistance to an alkaline aqueous hydrogen peroxide and being capable of planarizing a stepped substrate, materials of Patent Document 1 are proposed, for example. However, these materials have a problem that the dry-etching rate thereof is insufficient for the higher dry-etching rate required by customers.

Furthermore, as a protective film having favorable resistance to an alkaline aqueous hydrogen peroxide, Patent Document 2 etc. are proposed. However, although such materials have resistance to an alkaline aqueous hydrogen peroxide, there is a problem that the materials are insufficient regarding both the planarizing property on a stepped substrate and the dry-etching rate required by customers.

As explained above, there are demands for: a composition for forming a protective film against an alkaline aqueous hydrogen peroxide, the composition having high compatibility to a wet etching process (that is, excellent resistance to an alkaline aqueous hydrogen peroxide) and also exhibiting favorable filling and planarizing properties and excellent dry-etching properties; and a patterning process using the composition.

### CITATION LIST

### PATENT LITERATURE

Patent Document 1: JP2018-173521A
Patent Document 2: WO2020/209327A1

### SUMMARY OF INVENTION

### TECHNICAL PROBLEM

The present invention has been made in view of the above circumstances. An object of the present invention is to provide: a composition for forming a protective film against an alkaline aqueous hydrogen peroxide, the protective film being capable of exhibiting excellent resistance to an alkaline aqueous hydrogen peroxide, favorable filling and planarizing properties, and excellent dry-etching properties; a substrate for manufacturing a semiconductor device; a method for forming a protective film; and a patterning process.

### SOLUTION TO PROBLEM

To achieve the object, the present invention provides a composition for forming a protective film against an alkaline aqueous hydrogen peroxide, the composition comprising:
(A1) a polymer having a repeating unit represented by the following general formula (1A) and having a group represented by the following general formula (1B) as a terminal group; and
(B) an organic solvent, 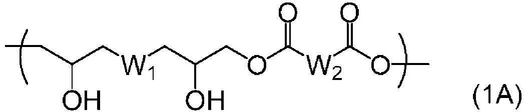
wherein W₁ represents a sulfinyl group, a sulfonyl group, an ether group, or a divalent organic group having 2 to 50 carbon atoms, and W₂ represents a divalent organic group having 2 to 50 carbon atoms.

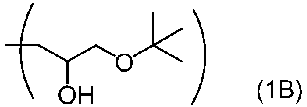

Such a composition for forming a protective film can exhibit favorable resistance to an alkaline aqueous hydrogen peroxide, excellent filling and planarizing properties, and excellent dry-etching properties.

The W₁ in the general formula (1A) preferably represents a divalent heterocyclic group having 3 to 10 carbon atoms.

Such a partial structure is preferably contained in the main chain from the viewpoint of excellent dry-etching properties.

The W₂ in the general formula (1A) preferably has an alicyclic structure.

Such a partial structure is preferably contained in the main chain from the viewpoint of achieving both high dry-etching rate and excellent resistance to an alkaline aqueous hydrogen peroxide.

The polymer (A1) preferably has a weight-average molecular weight of 1000 to 30000.

A composition for forming a protective film containing a polymer (A1) having a weight-average molecular weight Mw within such a range does not lose solubility in an organic solvent, and outgassing during baking can be suppressed with certainty.

The composition for forming a protective film preferably further comprises
(A2) an additional polymer including one or more kinds of a repeating unit represented by the following general formula (1C), 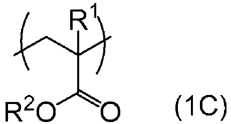
wherein R¹ represents a hydrogen atom or a methyl group, and R² represents a group selected from the group consisting of the following formulae (1-1) to (1-3), 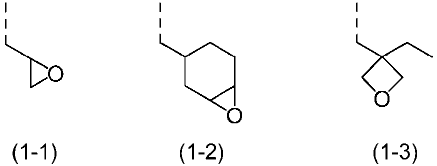
wherein a broken line represents an attachment point.

A composition for forming a protective film containing such an additional polymer (A2) can exhibit better resistance to an alkaline aqueous hydrogen peroxide, better filling and planarizing properties, and better dry-etching properties.

In this case, further preferably, the additional polymer (A2) further includes one or more kinds of a repeating unit represented by the following general formula (1D), 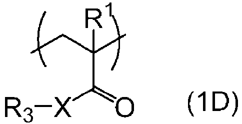 wherein R¹ represents a hydrogen atom or a methyl group, X represents -O- or -NH-, and R₃ represents an organic group having 2 to 10 carbon atoms and optionally containing an oxygen atom.

When such a repeating unit is contained, it is possible to adjust the rate of etching of the composition for forming a protective film containing the additional polymer (A2) by an alkaline aqueous hydrogen peroxide in accordance with customer requirements.

In this case, the additional polymer (A2) preferably further includes one or more kinds of a repeating unit represented by the following general formula (1E), 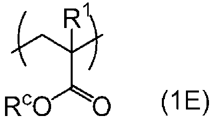 wherein R¹ represents a hydrogen atom or a methyl group, and R^{c} represents a monovalent group having an alicyclic structure and having 3 to 20 carbon atoms.

When an additional polymer (A2) including such a repeating unit is contained, it is possible to adjust the etching rate and etching properties, such as pattern profile after etching, of a protective film, being a cured product of the composition for forming a protective film against an alkaline aqueous hydrogen peroxide in accordance with customer requirements.

In this case, the additional polymer (A2) preferably has a weight-average molecular weight of 1,000 to 20,000.

When an additional polymer (A2) having such a weight-average molecular weight is contained, favorable film-formability for a protective film can be achieved and the generation of sublimation products during heat-curing can be suppressed, and the contamination of an apparatus due to sublimation products can be suppressed. Furthermore, the generation of coating defects can be suppressed, and even better filling and planarizing properties can be achieved.

The organic solvent (B) is preferably a mixture of one or more kinds of organic solvent having a boiling point of lower than 180°C and one or more kinds of organic solvent having a boiling point of 180°C or higher.

Such a composition for forming a protective film can achieve both high filling and high planarizing properties with more certainty by the polymer (A1) and any additional polymer (A2) being provided with thermal flowability of a film by virtue of the addition of a high-boiling-point solvent.

The composition for forming a protective film preferably further comprises one or more kinds selected from the group consisting of:
(C) an acid generator;
(D) a surfactant;
(E) a crosslinking agent;
(F) a plasticizer; and
(G) a colorant.

In this manner, the inventive composition for forming a protective film may further contain: (C) an acid generator for promoting crosslinking and curing reactions; (D) a surfactant for enhancing coating property in spin-coating; (E) a crosslinking agent for further promoting crosslinking and curing reactions; (F) a plasticizer for further enhancing filling and planarizing properties; and (G) a colorant for adjusting absorption property. By virtue of the presence or absence and choice of these additives, it is possible to make fine adjustments to performance, such as film-formability, curability, filling property, and optical characteristics, according to requirements, and this is preferable in terms of practical use.

The composition for forming a protective film preferably provides a protective film that exhibits resistance to an ammonia-containing aqueous hydrogen peroxide.

Such a composition for forming a protective film can realize a protective film that exhibits resistance to an ammonia-containing aqueous hydrogen peroxide.

Furthermore, the composition for forming a protective film is preferable a composition that, when a silicon substrate on which the protective film has been formed by the composition is immersed in a 1.0 mass% aqueous hydrogen peroxide containing ammonia at a concentration of 0.5 mass% at 70°C for 5 minutes, no removal of the protective film is observed.

Such a composition for forming a protective film can form a protective film having sufficient resistance to an alkaline aqueous hydrogen peroxide, and therefore, it is possible to increase options of substrates to be processed that can be processed, silicon middle layer films that can be removed by wet etching, etc.

The present invention also provides a substrate for manufacturing a semiconductor device, comprising:
a substrate; and
a protective film which is a cured product of the above-described composition for forming a protective film, formed on the substrate.

A protective film which is a cured product of the inventive composition for forming a protective film has both high filling and high planarizing properties, and therefore, is free from fine holes due to filling failure and unevenness on the protective film surface due to insufficient flatness. When a substrate for manufacturing a semiconductor device planarized with such a protective film is used, the process margin at the time of patterning can be widened, and it is possible to manufacture a semiconductor device with a good yield.

The present invention also provides a method for forming a protective film to be used in a process of manufacturing a semiconductor device, the method comprising:
spin-coating a substrate to be processed with the above-described composition for forming a protective film to obtain a coating film; and
curing the coating film by heating at a temperature of 100°C or higher and 600°C or lower for 10 to 600 seconds to obtain a cured film.

A protective film, formed by the inventive method for forming a protective film, to be applied in a process of manufacturing a semiconductor device has high filling and planarizing properties, and when used in a process of manufacturing a semiconductor device, a good semiconductor device yield can be achieved.

The substrate to be processed preferably has a structure or step having a height of 30 nm or more.

The inventive method for forming a protective film is particularly useful for forming a flat protective film on such a substrate to be processed.

The present invention also provides a patterning process for forming a pattern in a substrate to be processed, comprising the steps of:
(I-1) forming a protective film on a substrate to be processed by using the inventive composition for forming a protective film;
(I-2) forming a resist upper layer film on the protective film by using a photoresist material;
(I-3) forming a circuit pattern in the resist upper layer film; and
(I-4) transferring the pattern to the protective film by etching while using the resist upper layer film having the formed pattern as a mask.

Furthermore, the present invention provides a patterning process for forming a pattern in a substrate to be processed, comprising the steps of:
(II-1) forming a protective film on a substrate to be processed by using the inventive composition for forming a protective film;
(II-2) forming a silicon-containing resist middle layer film on the protective film by using a silicon-containing resist middle layer film material;
(II-3) forming a resist upper layer film on the silicon-containing resist middle layer film by using a photoresist composition;
(II-4) forming a circuit pattern in the resist upper layer film;
(II-5) transferring the pattern to the silicon-containing resist middle layer film by etching while using the resist upper layer film having the formed pattern as a mask;
(II-6) transferring the pattern to the protective film by etching while using the silicon-containing resist middle layer film having the transferred pattern as a mask; and
(II-7) forming the pattern in the substrate to be processed while using the protective film having the transferred pattern as a mask.

Furthermore, the present invention provides a patterning process for forming a pattern in a substrate to be processed, comprising the steps of:
(III-1) forming a protective film on a substrate to be processed by using the inventive composition for forming a protective film;
(III-2) forming an inorganic hard mask selected from the group consisting of a silicon oxide film, a silicon nitride film, a silicon oxynitride film, a titanium oxide film, and a titanium nitride film on the protective film;
(III-3) forming an organic antireflective coating on the inorganic hard mask;
(III-4) forming a resist upper layer film on the organic antireflective coating by using a photoresist composition, so that a 4-layered film structure is constructed, and forming a circuit pattern in the resist upper layer film;
(III-5) transferring the pattern to the organic antireflective coating and the inorganic hard mask by etching while using the resist upper layer film having the formed pattern as a mask;
(III-6) transferring the pattern to the protective film by etching while using the inorganic hard mask having the transferred pattern as a mask; and
(III-7) forming the pattern in the substrate to be processed while using the protective film having the transferred pattern as a mask.

The inventive composition for forming a protective film can be used suitably for various patterning processes such as: a 2-layer resist process using a resist upper layer film; a 3-layer resist process further using a silicon-containing resist middle layer film or an inorganic hard mask; and a 4-layer resist process using an organic antireflective coating in addition to these. When a circuit pattern is formed by an inventive patterning process described above in a process of manufacturing a semiconductor device, a semiconductor device can be manufactured with a good yield. Furthermore, as described above, a protective film formed using the inventive composition for forming a protective film has favorable resistance to an alkaline aqueous hydrogen peroxide, and therefore, the composition is also applicable to a wet etching process using an alkaline aqueous hydrogen peroxide.

The inorganic hard mask is preferably formed by a CVD method or an ALD method.

In the inventive patterning process, the inorganic hard mask can be formed by such methods, for example.

The present invention can further comprise, after the step (II-6), a step of removing the silicon-containing resist middle layer film having the transferred pattern by wet etching using an alkaline aqueous hydrogen peroxide.

A protective film formed using the inventive composition for forming a protective film has favorable resistance to an alkaline aqueous hydrogen peroxide, and therefore, the silicon-containing resist middle layer film can be removed by wet etching using an alkaline aqueous hydrogen peroxide as described above.

The inventive patterning processes can further comprise, after the step (I-4), the step (II-7), or the step (III-7), a step of transferring the pattern to the substrate to be processed by wet etching using an alkaline aqueous hydrogen peroxide while using the protective film having the transferred pattern as a mask.

A protective film formed using the inventive composition for forming a protective film has favorable resistance to an alkaline aqueous hydrogen peroxide, and therefore, the pattern can be transferred to the substrate to be processed by wet etching using an alkaline aqueous hydrogen peroxide as described above.

The inventive patterning processes can further comprise, after the step (I-4), the step (II-7), or the step (III-7), a step of pattern-processing the substrate to be processed by implanting ions while using the protective film having the transferred pattern as a mask.

Such patterning processes are particularly suitable for processing a substrate having unevenness on a surface by implanting ions.

In this case, the patterning processes may further comprise the step of, after the step of pattern-processing the substrate to be processed by implanting ions, removing the silicon-containing resist middle layer film having the transferred pattern by wet etching using an alkaline aqueous hydrogen peroxide.

A protective film formed using the inventive composition for forming a protective film has favorable resistance to an alkaline aqueous hydrogen peroxide, and therefore, it is also possible to remove, by wet etching using an alkaline aqueous hydrogen peroxide, the silicon-containing resist middle layer film after pattern-processing by ion implantation as described above.

The circuit pattern is preferably formed by a lithography using light with a wavelength of 10 nm or more to 300 nm or less, a direct drawing with electron beam, nanoimprinting, or a combination thereof.

Furthermore, the circuit pattern is preferably developed by alkali development or with an organic solvent.

In the inventive patterning process, such means for forming and developing the circuit pattern can be used suitably.

The substrate to be processed is preferably a semiconductor device substrate or the semiconductor device substrate coated with any of a metal film, a metal carbide film, a metal oxide film, a metal nitride film, a metal oxycarbide film, and a metal oxynitride film.

In this case, the substrate to be processed preferably contains silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

According to the inventive patterning process, such substrates to be processed can be processed to form a pattern.

### ADVANTAGEOUS EFFECTS OF INVENTION

As described above, the inventive composition for forming a protective film can provide a protective film with favorable resistance to an alkaline aqueous hydrogen peroxide, excellent filling and planarizing properties, and excellent dry-etching properties.

Furthermore, when the inventive substrate for manufacturing a semiconductor device is used, the process margin at the time of patterning can be widened, and it is possible to manufacture a semiconductor device with a good yield.

Furthermore, according to the inventive method for forming a protective film, it is possible to form a protective film having excellent resistance to an alkaline aqueous hydrogen peroxide, favorable filling and planarizing properties, and favorable dry-etching properties.

In addition, according to the inventive patterning processes, it is possible to form a fine pattern by a multilayer resist method (2-layer resist process, 3-layer resist process, or 4-layer resist process), and by the formation of a protective film, it is possible to fill steps on a substrate to be processed and planarize a substrate to be processed. Accordingly, the inventive patterning processes can be used suitably for a wet etching process, a process of planarizing by forming a protective film, and a process of removing a protective film by dry etching, and is extremely useful as a patterning process used in a multilayer resist process applied to fine patterning for manufacturing a semiconductor device.

### BRIEF DESCRIPTION OF DRAWINGS

FIG. 1 is an explanatory diagram of planarizing property in the present invention.
FIG. 2 is an explanatory diagram of an example of an inventive patterning process according to a 3-layer resist method.
FIG. 3 is an explanatory diagram of a method for evaluating the filling property in Examples.
FIG. 4 is an explanatory diagram of a method for evaluating the planarizing property in Examples.

### DESCRIPTION OF EMBODIMENTS

As described above, there have been demands for the development of: a composition for forming a protective film that can provide a protective film having favorable resistance to an alkaline aqueous hydrogen peroxide, favorable filling and planarizing properties, and excellent dry-etching properties; a patterning process using the composition; and a method for forming the protective film.

The present inventors have further studied earnestly in view of the above problem, and found out that, when a composition for forming a protective film contains a polymer (A1) having a polyester structure represented by the general formula (1A) in the main skeleton and having a group represented by the general formula (1B) introduced as a terminal group, it is possible to realize a protective film that exhibits excellent resistance to an alkaline aqueous hydrogen peroxide, favorable filling and planarizing properties, and excellent dry-etching properties. Thus, the present invention has been completed.

That is, the present invention is a composition for forming a protective film against an alkaline aqueous hydrogen peroxide, the composition comprising:
(A1) a polymer having a repeating unit represented by the following general formula (1A) and having a group represented by the following general formula (1B) as a terminal group; and
(B) an organic solvent, 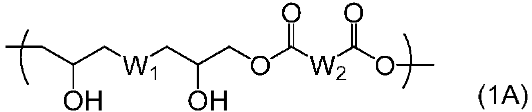
wherein W₁ represents a sulfinyl group, a sulfonyl group, an ether group, or a divalent organic group having 2 to 50 carbon atoms, and W₂ represents a divalent organic group having 2 to 50 carbon atoms.

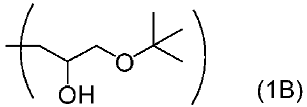

Hereinafter, the present invention will be described in detail, but the present invention is not limited thereto.

### <Composition for Forming Protective Film>

The inventive composition for forming a protective film is a composition for forming a protective film against an alkaline aqueous hydrogen peroxide, and contains a polymer (A1) and an organic solvent (B).

The polymer (A1) contained in the inventive composition for forming a protective film has a repeating unit represented by the general formula (1A). Since the repeating unit has a polyester structure, which is weak against etching gas, a protective film formed from the composition for forming a protective film can realize a high dry-etching rate. In addition, the polymer (A1) contained in the inventive composition for forming a protective film includes a group represented by the formula (1B) as a terminal group. Since a primary alcohol is protected in this terminal group, the viscosity of the polymer (A1) decreases, and favorable thermal flowability of the composition can be achieved at the time of application. Therefore, the inventive composition for forming a protective film makes it possible not only to fill favorably a fine structure formed on a substrate but also to form a protective film that allows the entire substrate to be flat. Furthermore, since the primary alcohol is protected, the alcohol is prevented from reacting with other functional groups, and therefore, the composition is also advantageous in view of storage stability. Furthermore, without wishing to be bound by theory, it is assumed that, in the polymer (A1) contained in the inventive composition for forming a protective film, the terminal structure becomes a diol structure by virtue of the deprotection of the protecting group of the primary alcohol during baking of a coating film of the composition, and that, therefore, an effect of enhancing the adhesiveness between the protective film and the substrate to be processed by virtue of the diol structure can be achieved, removal of the film during wet etching using an alkaline aqueous hydrogen peroxide can be suppressed, and as a result, favorable resistance to an alkaline aqueous hydrogen peroxide can be exhibited.

As a result, the inventive composition for forming a protective film can provide a protective film that exhibits favorable resistance to an alkaline aqueous hydrogen peroxide, excellent filling and planarizing properties, and excellent dry-etching properties.

In the following, the polymer (A1) and the organic solvent (B), which are essential components of the inventive composition for forming a protective film, will be described in detail. Note that the inventive composition for forming a protective film can further contain optional components besides the polymer (A1) and the organic solvent (B). Optional component will be described together later.

### [Polymer (A1)]

The polymer (A1) is a polymer having a repeating unit represented by the following general formula (1A) and having a group represented by the following general formula (1B) as a terminal group. The polymer (A1) can also be called a polymer for forming a protective film.

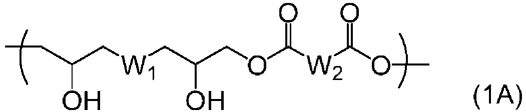

In the formula, W₁ represents a sulfinyl group, a sulfonyl group, an ether group, or a divalent organic group having 2 to 50 carbon atoms, and W₂ represents a divalent organic group having 2 to 50 carbon atoms.

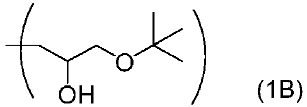

A high dry-etching rate can be realized by virtue of the repeating unit of the polymer (A1) having a polyester structure, which is weak against etching gas, as in the formula (1A). By selecting appropriate structures as W₁ and/or W₂ depending on the purpose, it is possible to adjust properties, such as etching resistance, heat resistance, optical constants, polarity, and flexibility, of the protective film to be formed.

More specific examples of the W₁ include the structures shown below, but are not limited thereto. Note that, in the following formulae, a broken line represents an attachment point.

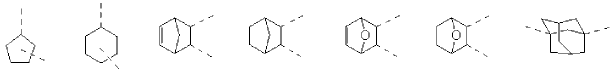

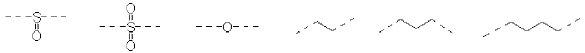

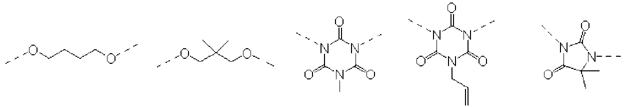

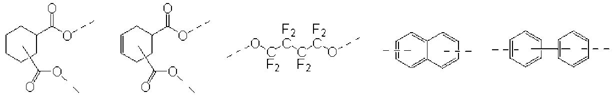

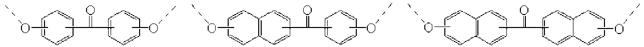

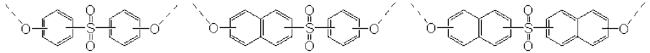

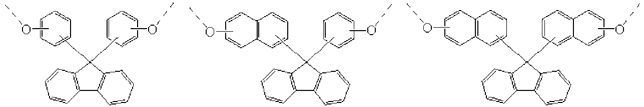

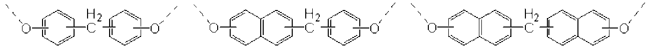

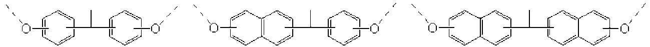

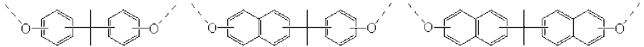

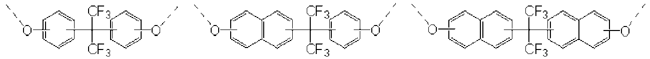

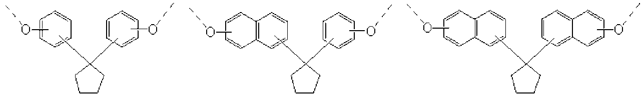

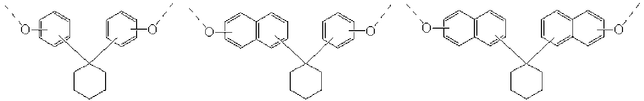

Furthermore, the W₁ in the general formula (1A) preferably represents a divalent heterocyclic group having 3 to 10 carbon atoms.

It is preferable that the polymer (A1) has such a partial structure in the main chain from the viewpoint of a high dry-etching rate.

More specific examples of the W₂ include the structures shown below, but are not limited thereto. Note that, in the following formulae, a broken line represents an attachment point.

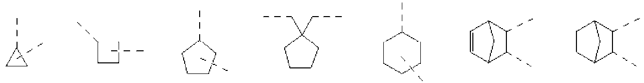

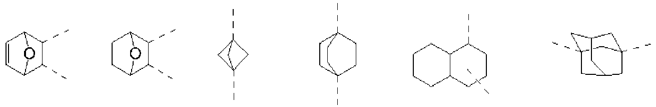

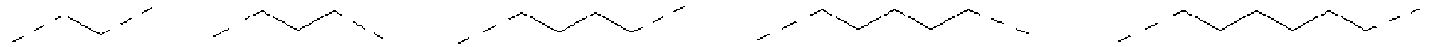

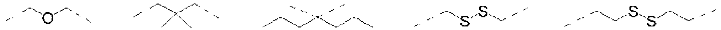

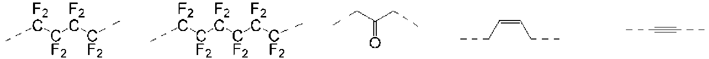

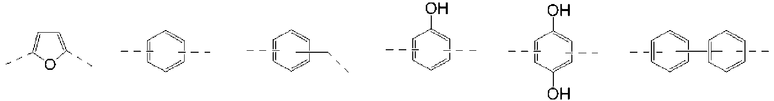

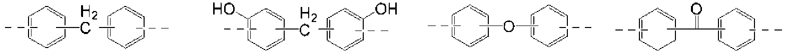

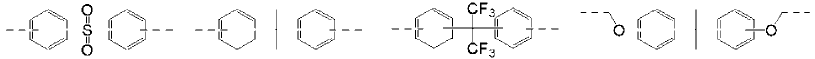

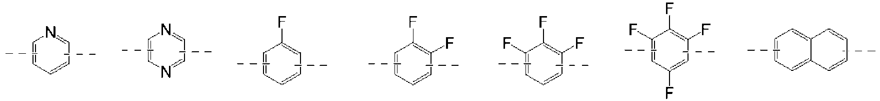

Furthermore, the W₂ in the general formula (1A) preferably has an alicyclic structure.

It is preferable that the polymer (A1) has such a partial structure in the main chain from the viewpoint of achieving both a high dry-etching rate and excellent resistance to an alkaline aqueous hydrogen peroxide.

Furthermore, to repeat, the polymer (A1) contained in the inventive composition for forming a protective film includes a group represented by the formula (1B) as a terminal group, and by a primary alcohol being protected in this terminal group, the viscosity of the polymer (A1) decreases, and favorable thermal flowability of the composition for forming a protective film can be achieved at the time of application. Therefore, the inventive composition for forming a protective film makes it possible not only to fill favorably a fine structure formed on a substrate but also to form a protective film that allows the entire substrate to be flat. Furthermore, since the alcohol is prevented from reacting with other functional groups, the inventive composition for forming a protective film is also advantageous in view of storage stability. Furthermore, without wishing to be bound by theory, it is assumed that, in the polymer (A1), the terminal structure becomes a diol structure by virtue of the deprotection of the protecting group of the primary alcohol during baking of a coating film of the composition as shown below, and that, therefore, an effect of enhancing the adhesiveness between the protective film and the substrate to be processed by virtue of the diol structure can be achieved, removal of the film during wet etching using an alkaline aqueous hydrogen peroxide can be suppressed, and as a result, favorable resistance to an alkaline aqueous hydrogen peroxide can be exhibited.

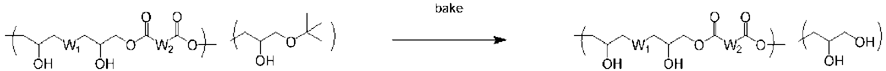

Furthermore, the polymer (A1) preferably has an Mw (weight-average molecular weight) of 1000 to 30000, more preferably 1000 to 8000, and further preferably 1500 to 5000. Note that, in the present invention, the weight-average molecular weight (Mw) can be measured by gel permeation chromatography (GPC) using tetrahydrofuran as an eluent in terms of polystyrene.

When the polymer (A1) has such a molecular weight, solubility in the organic solvent (B) can be ensured more fully, and sublimation products generated during baking can be suppressed. In addition, favorable thermal flowability of the polymer (A1) (polymer for forming a protective film) can be achieved, and thereby, when the polymer is contained in the composition for forming a protective film, not only is it possible to fill more favorably a fine structure formed on the substrate, it is also possible to form more certainly a protective film that can planarize the entire substrate.

The inventive composition for forming a protective film may contain one kind of the polymer (A1), or may contain a combination of two or more kinds of the polymer (A1).

### [Method for Manufacturing Polymer (A1)]

Means for obtaining the polymer (A1) contained in the inventive composition for forming a protective film are not limited, but, for example, the polymer can be obtained by an addition reaction of a diepoxy compound, a dicarboxylic acid, and tert-butyl glycidyl ether shown below. As the diepoxy compound and the dicarboxylic acid used in the synthesis, one kind of each compound may be used, or two or more kinds of each may be used. These compounds can be selected and used in combination appropriately according to the required properties. The W₁ and the W₂ in the following formulae are as defined above.

### [Charging At Once]

There is a method of allowing a diepoxy compound, a dicarboxylic acid, and tert-butyl glycidyl ether to react at once, as shown below.

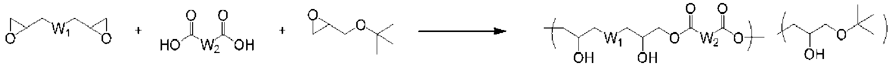

### [End-Capping]

There is a method of reacting a diepoxy compound with excessive dicarboxylic acid, and then end-capping the product with tert-butyl glycidyl ether, as shown below.

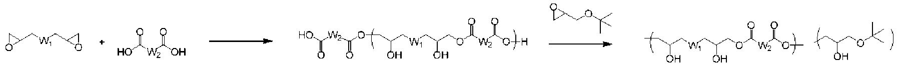

The ratio between the amounts of the epoxy compound and the carboxylic acid compound is preferably such that the amount of carboxy groups in the carboxylic acid compound is preferably 0.3 to 2.0 mol, more preferably 0.5 to 1.5 mol, and further preferably 0.75 to 1.25 mol based on 1 mol of epoxy groups in the epoxy compound. When the amount of carboxy groups relative to the amount of epoxy groups is appropriate as described, there is no risk of the storage stability of the composition for forming a protective film being degraded due to unreacted epoxy groups remaining, and it is possible to prevent unreacted carboxylic acid compound remaining and causing outgassing.

Furthermore, to improve required properties, for example, resistance to an alkaline aqueous hydrogen peroxide, filling property, planarizing property, dry-etching properties, etc., multiple kinds of epoxy compounds and/or multiple kinds of carboxylic acid compounds may be used in combination. Incidentally, the ratio between the amounts of epoxy groups and carboxy groups is preferably within the above-described range in this case as well.

The polymer (A1) to be contained in the inventive composition for forming a protective film can usually be obtained by reacting an epoxy compound and a carboxylic acid compound such as those described above without a solvent or in a solvent in the presence of a reaction catalyst at room temperature or under cooling or heating as necessary.

Specific examples of the solvent used in this event include: alcohols, such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; lactones, such as γ-butyrolactone; and aprotic polar solvents, such as dimethyl sulfoxide, N,N-dimethylformamide, and hexamethylphosphoric triamide. One of these solvents may be used, or two or more kinds thereof may be used in mixture. These solvents are preferably used in an amount of 0 to 2,000 parts by mass based on 100 parts by mass of the reaction raw materials.

Specific examples of the reaction catalyst include quaternary ammonium salts, such as benzyltriethylammonium chloride, benzyltriethylammonium bromide, benzyltrimethylammonium chloride, tetramethylammonium chloride, tetramethylammonium bromide, tetramethylammonium iodide, tetramethylammonium hydroxide, tetraethylammonium bromide, tetrabutylammonium chloride, tetrabutylammonium bromide, tetrabutylammonium iodide, tetrabutylammonium hydrogen sulfate, trioctylmethylammonium chloride, tributylbenzylammonium chloride, trimethylbenzylammonium chloride, trimethylbenzylammonium hydroxide, N-laurylpyridinium chloride, N-lauryl-4-picolinium chloride, N-laurylpicolinium chloride, trimethylphenylammonium bromide, and N-benzylpicolinium chloride; quaternary phosphonium salts, such as tetrabutylphosphonium chloride, tetrabutylphosphonium bromide, and tetraphenylphosphonium chloride; tertiary amines, such as tris[2-(2-methoxyethoxy)ethyl]amine, tris(3,6-dioxaheptyl)amine, and tris(3,6-dioxaoctyl)amine; etc. The amount of the catalyst to be used is preferably 0.001 to 100 weight%, more preferably 0.005 to 50 weight%, with respect to the raw materials. The reaction temperature is preferably about -50°C to the boiling point of the solvent, more preferably room temperature to 150°C. The reaction time is appropriately selected within a range of 0.1 to 100 hours. Note that, in the present description, the boiling point of a solvent is the boiling point at the standard atmospheric pressure (1 atm = 1013.25 hPa).

Examples of reaction methods include: a method in which an epoxy compound, a carboxylic acid compound, tert-butyl glycidyl ether, and a catalyst are charged at once; a method in which an epoxy compound, a carboxylic acid compound, and tert-butyl glycidyl ether are dispersed or dissolved in a solvent, and then a catalyst is added at once thereto or diluted with a solvent and added dropwise thereto; and a method in which a catalyst is dispersed or dissolved in a solvent, and then an epoxy compound, a carboxylic acid compound, and tert-butyl glycidyl ether are added at once thereto or diluted with a solvent and added dropwise thereto. After completion of the reaction, the reaction product may be directly used as a composition for forming a protective film or the reaction product may be diluted with an organic solvent and then subjected to liquid-liquid separation washing to remove unreacted raw materials, the catalyst, and so forth present in the system, and thus, the product can be collected.

The organic solvent to be used in this event is not particularly limited, as long as the organic solvent is capable of dissolving the compounds and is separated into two layers when mixed with water. Examples of the organic solvent include: hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; etc. As washing water used in this event, generally, what is called deionized water or ultrapure water may be used. The washing may be performed one or more times, preferably approximately one to five times because washing ten times or more does not always produce the full washing effects thereof.

In the liquid-liquid separation washing, the washing may be performed with a basic aqueous solution to remove the unreacted carboxylic acid compound or acidic components in the system. The base specifically includes hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove the metal impurities or basic components in the system. The acid specifically includes inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; etc.

The liquid-liquid separation washing using a basic aqueous solution and/or an acidic aqueous solution may be performed with either one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or the acidic aqueous solution, washing with neutral water may be successively performed. As the neutral water, deionized water, ultrapure water, or the like as mentioned above may be used. The washing may be performed one or more times, but in order to remove the basic components and the acidic components sufficiently, the washing is preferably performed multiple times. The washing is preferably performed approximately one to five times because washing ten times or more does not always produce the full washing effects thereof.

Further, the reaction product after the liquid-liquid separation washing can also be collected as a powder by concentrating and drying up the solvent or crystallizing the reaction product under reduced pressure or normal pressure. Alternatively, the reaction product can also be retained in the state of solution with an appropriate concentration to improve the workability in preparing the composition for forming a protective film. The concentration in this event is preferably 0.1 to 50 mass%, more preferably 0.5 to 30 mass%. With such a concentration, the viscosity is hardly increased, and therefore, it is possible to prevent degradation of workability; in addition, since the amount of the solvent is not excessive, it is economical.

The solvent used in this event is not particularly limited, as long as the solvent is capable of dissolving the compound. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

Furthermore, when manufacturing the polymer (A1) to be used for the inventive composition for forming a protective film, it is possible to combine appropriately various epoxy compounds and carboxylic acid compounds according to the required performance. Specifically, it is possible to introduce a substituent that contributes to the improvement of solvent solubility, adhesiveness, and filling and planarizing properties, a substituent that contributes to etching resistance and/or film-formability, a substituent that contributes to resistance to an alkaline aqueous hydrogen peroxide, etc. in accordance with the required performance desired. A composition for forming a protective film containing such a polymer (A1) can achieve all of high filling and planarizing properties, high dry-etching properties, and high resistance to an alkaline aqueous hydrogen peroxide.

As described above, the polymer (A1), which is the component (A1), can give a composition for forming a protective film having high filling and planarizing properties, high dry etching-properties, and high resistance to an alkaline aqueous hydrogen peroxide.

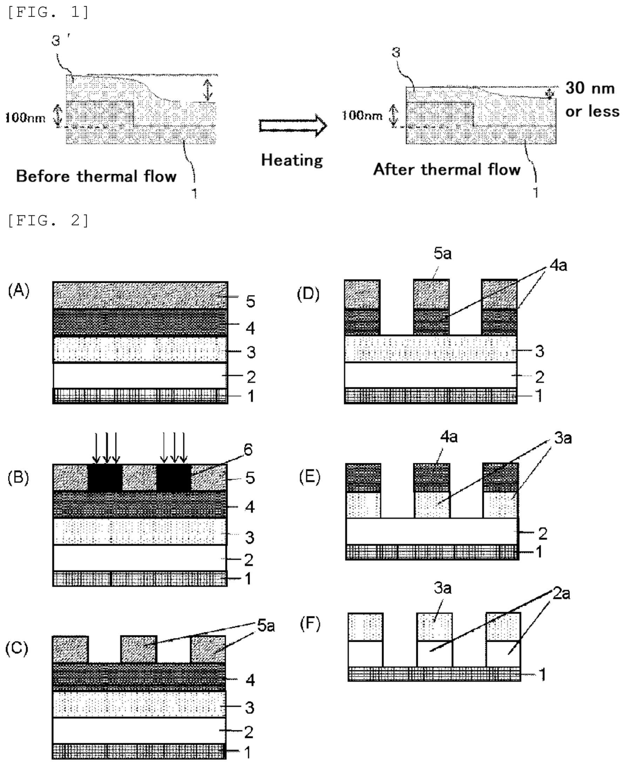

Note that, in the present invention, planarizing property is the ability to planarize a substrate surface. In the case of the inventive composition for forming a protective film, for example, as shown in FIG. 1, the composition 3' for forming a protective film can be applied onto a substrate 1 and heated to form a protective film 3, and thus, a 100-nm step in the substrate 1 can be reduced to be 30 nm or less. Note that the shape of the step shown in FIG. 1 shows a typical example of a step shape in a substrate for manufacturing a semiconductor device, and the step shapes of substrates that can be planarized with the inventive composition for forming a protective film is, of course, not limited thereto.

### [Organic Solvent (B)]

The inventive composition for forming a protective film contains an organic solvent (B) as an essential component.

The organic solvent (B) usable in the inventive composition for forming a protective film is not particularly limited as long as the solvent is capable of dissolving the above-described polymer (polymer for forming a protective film) (A1) and optional components described later. Specifically, for example, it is possible to use a solvent having a boiling point lower than 180°C (low-boiling point solvent), such as the solvents disclosed in paragraphs (0091) and (0092) in JP2007-199653A. In particular, propylene glycol monomethyl ether acetate, propylene glycol monomethyl ether, 2-heptanone, cyclopentanone, cyclohexanone, and mixtures of two or more of these are preferably used. The organic solvent (B) is preferably contained in an amount of 200 to 10,000 parts by mass, more preferably 300 to 5,000 parts by mass, based on 100 parts by mass of the polymer (A1).

Such a composition for forming a protective film can be applied by spin-coating, and in addition, contains the polymer (A1) component described above, and therefore, can have resistance to an alkaline aqueous hydrogen peroxide, favorable filling and planarizing properties, and excellent dry-etching properties.

The organic solvent (B) can also be a solvent in which a solvent having a boiling point of 180°C or higher (high-boiling-point solvent) is added to the aforementioned low-boiling-point solvent, having a boiling point of lower than 180°C (mixture of a solvent having a boiling point of lower than 180°C and a solvent having a boiling point of 180°C or higher).

The high-boiling-point organic solvent is not particularly limited to hydrocarbons, alcohols, ketones, esters, ethers, chlorinated solvents, and so forth as long as the high-boiling-point solvent is capable of dissolving the polymer (A1). Specific examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. As the high-boiling-point solvent, one of these may be used, or two or more thereof may be used in mixture.

The boiling point of the high-boiling-point solvent may be appropriately selected according to the temperature at which the composition for forming a protective film is heated. The boiling point of the high-boiling-point solvent to be contained is preferably 180°C to 300°C, further preferably 200°C to 300°C. Such a boiling point prevents the evaporation rate at baking (heating) from becoming excessive, which would otherwise occur if the boiling point is too low. Thus, sufficient thermal flowability can be achieved. Meanwhile, with such a boiling point, the high-boiling-point solvent does not remain in the film without evaporating after baking due to the boiling point being too high. Thus, the boiling point in these ranges does not adversely affect the film physical properties, such as etching resistance.

When the high-boiling-point solvent is used, the contained amount of the high-boiling-point solvent is preferably 1 to 30 parts by mass based on 100 parts by mass of the solvent having a boiling point of lower than 180°C. When the contained amount is as described, there is no risk of sufficient thermal flowability not being provided at the time of baking due to the contained amount being too small or risk of the solvent remaining in the film and causing degradation in film physical properties, such as etching resistance, due to the contained amount being too large.

With such a composition for forming a protective film, the above-described polymer (A1) is provided with thermal flowability by the addition of the high-boiling-point solvent, so that the composition for forming a protective film also has higher filling and planarizing properties.

### [Optional Components]

The inventive composition for forming a protective film can further contain components other than the polymer (A1) and the organic solvent (B) as optional components. In the following, optional components of the inventive composition for forming a protective film will be described.

### [Additional Polymer (A2)]

The inventive composition for forming a protective film preferably further contains, as a component (A2), an additional polymer (A2) including one or more kinds of a repeating unit represented by the following general formula (1C).

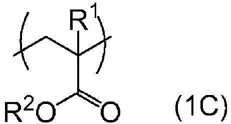

In the formula, R¹ represents a hydrogen atom or a methyl group, and R² represents a group selected from the group consisting of the following formulae (1-1) to (1-3).

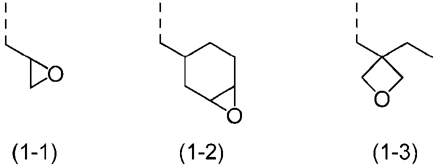

In the formulae, a broken line represents an attachment point.

A composition for forming a protective film containing such an additional polymer (A2) can exhibit better resistance to an alkaline aqueous hydrogen peroxide, better filling and planarizing properties, and better dry-etching properties. Furthermore, by such an additional polymer (A2) being contained, coating-film-formability can be enhanced, and in addition, the range in which etching resistance can be adjusted can be extended.

When the additional polymer (A2) is contained, the additional polymer (A2) is preferably contained in an amount of 5 to 2,000 parts by mass, more preferably 20 to 1,000 parts by mass, based on 100 parts by mass of the polymer (A1) for forming a protective film. When the contained amount of the additional polymer (A2) is 5 parts by mass or more, the blending effect can be achieved sufficiently, and on the other hand, when the contained amount of the additional polymer (2A) is 2,000 parts by mass or less, the resistance to an alkaline aqueous hydrogen peroxide can be achieved sufficiently.

A characteristic of the additional polymer (A2) is that the polymer includes one or more kinds of a repeating unit represented by the general formula (1C). The repeating unit represented by the general formula (1C) provides the effect of providing the additional polymer (A2) with sufficient thermosetting property to prevent intermixing with an upper layer film. In addition, it can be assumed that the repeating unit also has some contribution to the resistance to an alkaline aqueous hydrogen peroxide.

In the general formula (1C), R¹ represents a hydrogen atom or a methyl group. When R¹ is a hydrogen atom, the additional polymer (A2) is excellent in flowability, and therefore, may be excellent in planarizing and filling properties, or has a smaller carbon content, and therefore, may be excellent in etching rate. On the other hand, when R¹ is a methyl group, the inventive composition for forming a protective film may be excellent in film-formability and coating property. R² represents a group selected from the group consisting of the formulae (1-1) to (1-3).

The additional polymer (A2) may have only one kind of the repeating unit represented by the general formula (1C), or may have two or more kinds thereof. The repeating unit represented by the general formula (1C) is, specifically, as follows.

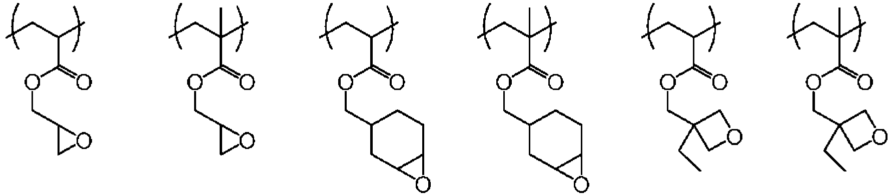

The additional polymer (A2) more preferably further includes one or more kinds of a repeating unit represented by the following general formula (1D).

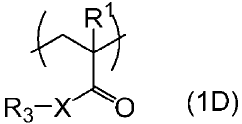

In the formula, R¹ represents a hydrogen atom or a methyl group, X represents -O- or -NH-, and R₃ represents an organic group having 2 to 10 carbon atoms and optionally containing an oxygen atom.

The repeating unit represented by the general formula (1D) makes it possible to adjust the rate of the etching, using an alkaline aqueous hydrogen peroxide, of the composition for forming a protective film according to customer requirements.

In the general formula (1D), R¹ represents a hydrogen atom or a methyl group. X represents -O- or - NH-. R₃ represents an organic group having 2 to 10 carbon atoms and optionally containing an oxygen atom. More specific examples of R₃ include the structures shown below, but are not limited thereto. Note that, in the following formulae, a broken line represents an attachment point.

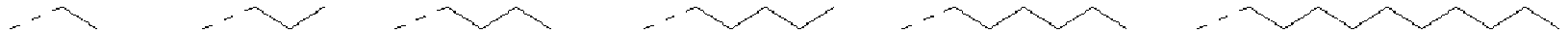

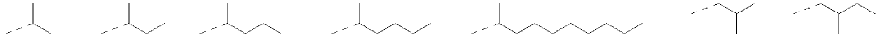

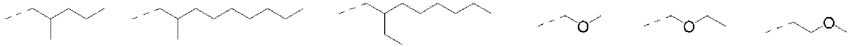

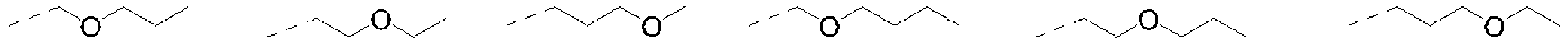

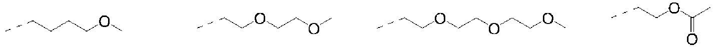

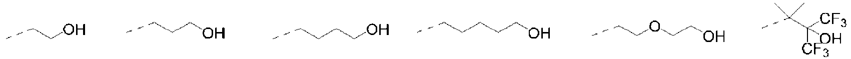

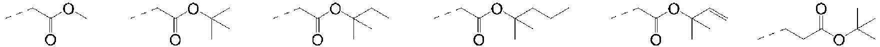

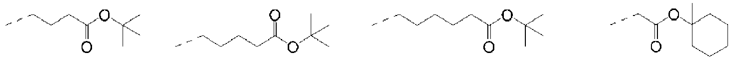

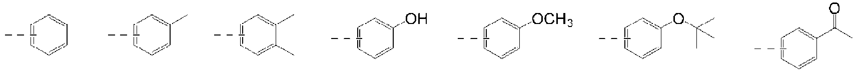

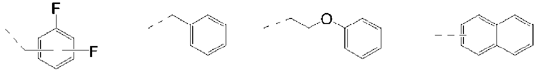

The additional polymer (A2) more preferably further includes one or more kinds of a repeating unit represented by the following general formula (1E).

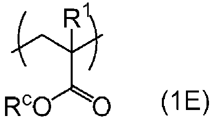

In the formula, R¹ represents a hydrogen atom or a methyl group, and R^{c} represents a monovalent group having an alicyclic structure and having 3 to 20 carbon atoms.

When an additional polymer (A2) into which a repeating unit represented by the general formula (1E) has been introduced in an appropriate amount is contained in the composition for forming a protective film, it is possible to adjust the etching properties, such as the etching rate and the pattern profile after etching of a protective film which is a cured product of the composition, according to customer requirements.

In the general formula (1E), R¹ represents a hydrogen atom or a methyl group. R^{c} represents a monovalent group having an alicyclic structure and having 3 to 20 carbon atoms. More specific examples of R^{c} include a cyclopropyl group, a cyclobutyl group, a cyclopentyl group, a cyclohexyl group, a cycloheptyl group, a dicycloheptyl group, a dicyclooctyl group, a dicyclononyl group, a dicyclodecanyl group, a tricyclodecanyl group, an adamantyl group, a tetracyclododecanyl group, a cyclohexylmethyl group, a dicycloheptylmethyl group, an isobornyl group, a menthyl group, a hydroxycyclohexyl group, a hydroxydicycloheptyl group, a hydroxyadamantyl group, a 1-methylcyclopropyl group, a 1-methylcyclopentyl group, a 1-ethylcyclopentyl group, a 1-methylcyclohexyl group, a 1-ethylcyclohexyl group, a 1-cyclopentylcyclopentyl group, a 1-cyclohexylcyclopentyl group, a 1-methylcyclohexyl group, a 1-ethylcyclohexyl group, a 1-cyclopentylcyclohexyl group, a 1-cyclohexylcyclohexyl group, a 2-methyl-2-norbonyl group, a 2-ethyl-2-norbonyl group, a 8-methyl-8-tricyclo[5.2.1.0^{2,6}]decyl group, a 8-ethyl-8-tricyclo[5.2.1.0^{2,6}]decyl group, a 3-methyl-3-tetracyclo[4.4.0.1^{2,5},1^{7,10}]dodecyl group, a 3-ethyl-3-tetracyclo[4.4.0.1^{2,5},1^{7,10}]dodecyl group, a 2-methyl-2-adamantyl group, a 2-ethyl-2-adamantyl group, a 1-adamantyl-1-methylethyl group, a 1-methyl-3-oxo-1-cyclohexyl group, a 1-methyl-1-(tetrahydrofuran-2-yl)ethyl group, a 5-hydroxy-2-methyl-2-adamantyl group, a 5-hydroxy-2-ethyl-2-adamantyl group, a butyrolactonyl group, a valerolactonyl group, a 1,3-cyclohexanecarbolactonyl group, a 4-oxa-5-oxotricyclo[5.2.1.0^{2,6}]decyl group, a 2,6-norbornanecarbolactone-3-ylmethyl group, a 2,6-norbornanecarbolactone-5-yl group, a 3-methoxycarbonyl-2,6-norbornanecarbolactone-5-yl group, and a 7-oxa-2,6-norbornanecarbolactone-5-yl group. When an optimum structure is selected as R^{c} in accordance with the use, properties of the entire polymer, such as the carbon density and polarity, can be optimally controlled so that the characteristics of the protective film formed using this polymer can be adjusted as well.

In the present invention, the mole fraction of the repeating unit represented by the general formula (1C) in the additional polymer (A2) is preferably 20% or more and 90% or less, more preferably 25% or more and 70% or less. When the mole fraction is 20% or more, sufficient curability can be achieved. When the mole fraction is 90% or less, sufficient planarizing property and etching property can be achieved. The mole fraction of the repeating unit represented by the general formula (1D) is preferably 5% or more and 50% or less, more preferably 5% or more and 40% or less. When the mole fraction is 5% or more and 50% or less, sufficient etching property can be achieved.

Meanwhile, when the sum of the mole fractions of the repeating units represented by each of the general formula (1C) and the general formula (1D) does not reach 100%, the additional polymer (A2) includes other repeating units. In this case, illustrative examples of the other repeating units include the above-described repeating unit represented by the general formula (1E) and/or repeating units derived from any one of: α,β-unsaturated carboxylate esters, such as other acrylate esters, other methacrylate esters, crotonate esters, maleate esters, and itaconate esters; α,β-unsaturated carboxylic acids, such as methacrylic acid, acrylic acid, maleic acid, and itaconic acid; acrylonitrile; methacrylonitrile; α, β-unsaturated lactones, such as 5,5-dimethyl-3-methylene-2-oxotetrahydrofuran; cyclic olefins, such as norbornene derivatives and tetracyclo[4.4.0.1^{2,5}.1^{7,10}]dodecene derivatives; α,β-unsaturated carboxylic acid anhydrides, such as maleic anhydride and itaconic anhydride; allyl ethers; vinyl ethers; vinyl esters; and vinyl silanes.

The additional polymer (A2) preferably has a weight-average molecular weight of 1,000 to 20,000. The weight-average molecular weight is based on a value measured by gel permeation chromatography (eluent of tetrahydrofuran and the polystyrene standard). The weight-average molecular weight of the additional polymer (A2) is preferably 1,000 to 20,000, more preferably 1,500 to 15,000, and further preferably 2,000 to 10,000. When the weight-average molecular weight is 1,000 or more, there is no risk of poor film-formability, and there is no risk of contamination of equipment due to increase in sublimation products during heat-curing. Meanwhile, when the weight-average molecular weight is 20,000 or less, there is no risk of coating defects being formed, and there is no risk of degradation in the planarizing and filling properties due to decrease in flowability.

Furthermore, in the inventive composition for forming a protective film, the glass transition temperature of the additional polymer (A2) is preferably 50°C or lower, further preferably 25°C or lower. A composition for forming a protective film containing such an additional polymer (A2) is particularly excellent in properties of planarizing and filling by virtue of the formation of a protective film, and therefore, is particularly suitable for the processing of a substrate having an uneven surface.

Furthermore, in the inventive composition for forming a protective film, the GPC dispersity of the additional polymer (A2) is preferably 2.0 or less, further preferably 1.8 or less. When the composition for forming a protective film contains such an additional polymer (A2), the generation of sublimation products during the formation of a protective film is small, so that contamination of equipment can be suppressed, and this is excellent for practical use.

Specific examples of the additional polymer (A2) include the following polymers, but are not limited thereto.

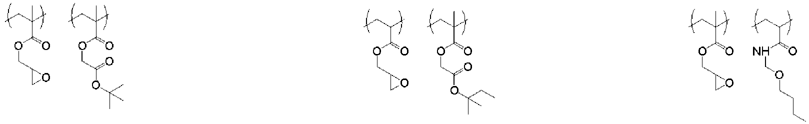

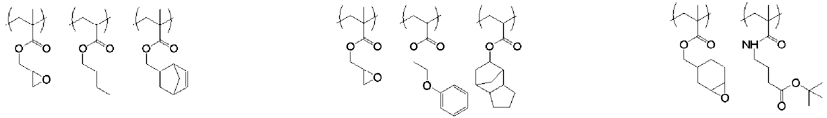

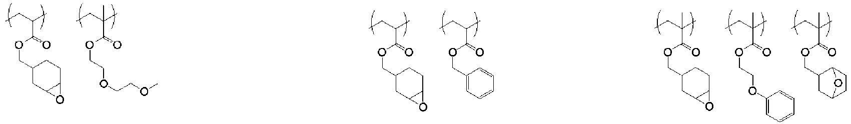

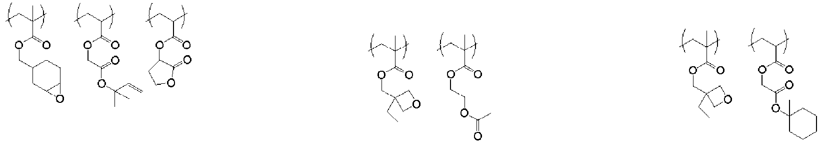

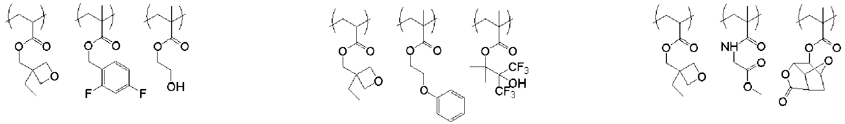

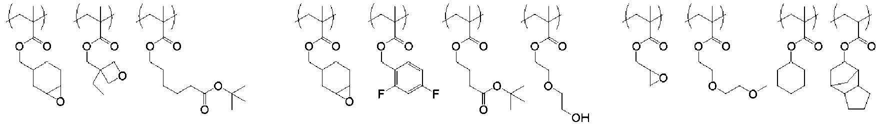

In the present invention, one kind of the additional polymer (A2) may be used, or two or more kinds thereof may be used in mixture. Alternatively, the additional polymer (A2) may be used as a mixture including a resin not containing the repeating units represented by the general formulae (1C), (1D), or (1E). In this case, the resin that may be mixed therewith is not particularly limited, and known resins may be used. However, specifically, an acrylic resin, a styrenic resin, a phenol resin, a polyether resin, and an epoxy resin are preferable.

Here, to synthesize the additional polymer (A2), one method is to mix monomers each corresponding to the respective repeating unit and having polymerizable unsaturated bond, and then carry out thermal polymerization of the mixture in a solvent by addition of a radical initiator. Thus, the additional polymer (A2) can be obtained. Various polymerization conditions can be chosen in accordance with the monomers to be used, the target molecular weight, etc., and the conditions are not particularly limited. Specific examples of the solvent to be used in the polymerization include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, and butyl acetate. Illustrative examples of the polymerization initiator include 2,2'-azobisisobutyronitrile (AIBN), 2,2'-azobis(2,4-dimethylvaleronitrile), dimethyl 2,2-azobis(2-methylpropionate), benzoyl peroxide, and lauroyl peroxide. As a chain transfer agent, a thiol such as octanethiol or 2-mercaptoethanol may be added at the time of polymerization. The polymerization reaction may be carried out by heating in the temperature range of preferably 40°C to a boiling point of the reaction solvent. The reaction time is, for example, 0.5 to 100 hours, preferably 1 to 48 hours.

For example, it is possible to synthesize a polymer (polymer compound) having the repeating units represented by the general formulae (1C), (1D), and (1E) by performing polymerization like that described above using, as monomers, compounds represented by the following general formulae (1C-1), (1D-1), and (1E-1), each having a polymerizable double bond.

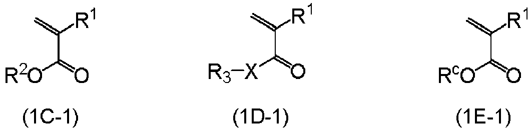

In the general formulae (1C-1), (1D-1), and (1E-1), R¹, R², R³, X, and R^{c} are as defined above.

The polymerization may be carried out in such a way that heating is carried out after all the raw materials are mixed, or alternatively, part of the raw materials is heated in advance, and then, the rest of the raw materials is added separately or as a mixture, all at once or gradually. For example, the polymerization method in which only the polymerization solvent is heated, and then a monomer solution and an initiator solution are separately and gradually added thereto may be employed. This method not only can give a relatively homogeneous polymer but also can prevent an abnormal reaction such as a runaway reaction; and thus, this method is especially preferable.

The polymerization solution thus obtained may be contained in the composition for forming a protective film as it is. Alternatively, the polymer may be purified by using a usual method, such as crystallization, phase separation, filtration, or concentration so as to remove residual monomers, residual solvent, reaction by-products, and other impurities as necessary. When the additional polymer (A2) is purified, a preferable method is a crystallization method in which a poor solvent, such as water, a water-containing alcohol, or a saturated hydrocarbon, is added into the polymerization solution and the formed precipitate is collected by filtration, or a phase separation method in which a poor solvent phase is removed by separation; among these methods, the phase separation method is especially preferable. When the polymer is purified by the phase separation method, low-molecular-weight components in the polymerization solution can be efficiently removed, and therefore, it is possible to suppress the generation of sublimation products during the formation of a protective film from the composition for forming a protective film that contains the polymer (A1) and the additional polymer (A2); and thus, this is preferable in view of prevention of contamination of the film-forming equipment.

### [(C) Acid Generator]

In the inventive composition for forming a protective film, an acid generator (C) can be contained so as to further promote the curing reaction. The acid generator includes a material that generates an acid by thermal decomposition and a material that generates an acid by light irradiation. Any acid generator can be contained. Specifically, materials disclosed in paragraphs (0061) to (0085) of JP2007-199653A can be contained, but the present invention is not limited thereto.

One of the acid generators or a combination of two or more thereof can be used. When an acid generator is contained, the contained amount is preferably 0.05 to 50 parts, more preferably 0.1 to 10 parts based on 100 parts of the polymer (A1).

### [(D) Surfactant]

In the inventive composition for forming a protective film, a surfactant (D) can be contained for improving coatability in spin-coating. As the surfactant, it is possible to use, for example, a surfactant disclosed in paragraphs (0142) to (0147) of JP2009-269953A. When a surfactant is contained, the contained amount is preferably 0.01 to 10 parts by mass, more preferably 0.05 to 5 parts by mass, based on 100 parts by mass of the polymer (A1).

### [(E) Crosslinking Agent]

Moreover, in the inventive composition for forming a protective film, a crosslinking agent (E) can also be contained so as to increase the curability and to further suppress intermixing with a film which is to be formed on the protective film. The crosslinking agent is not particularly limited, and known various types of crosslinking agents can be widely used. Examples thereof include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and epoxy-based crosslinking agents.

Specific examples of the melamine-based crosslinking agents include hexamethoxymethylated melamine, hexabutoxymethylated melamine, alkoxy- and/or hydroxy-substituted derivatives thereof, and partial self-condensates thereof. Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof. Specific examples of the urea-based crosslinking agents include dimethoxymethylated dimethoxyethyleneurea, alkoxy-and/or hydroxy-substituted derivatives thereof, and partial self-condensates thereof. Specific examples of the β-hydroxyalkylamide-based crosslinking agents include N,N,N',N'-tetra(2-hydroxyethyl)adipic acid amide. Specific examples of the isocyanurate-based crosslinking agents include triglycidyl isocyanurate and triallyl isocyanurate. Specific examples of the aziridine-based crosslinking agents include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis(4,5-diphenyl-2-oxazoline), 2,2'-methylenebis(4-phenyl-2-oxazoline), 2,2'-methylenebis(4-tert-butyl-2-oxazoline), 2,2'-bis(2-oxazoline), 1,3-phenylenebis(2-oxazoline), 1,4-phenylenebis(2-oxazoline), and a 2-isopropenyloxazoline copolymer. Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

When the crosslinking agent is contained, the contained amount is preferably 1 to 100 parts by mass, more preferably 5 to 50 parts by mass, based on 100 parts by mass of the polymer (A1).

### [(F) Plasticizer]

Furthermore, in the inventive composition for forming a protective film, a plasticizer (F) can be contained so as to further enhance the planarizing and filling properties. The plasticizer is not particularly limited, and known various types of plasticizers can be widely used. Examples thereof include low-molecular-weight compounds, such as phthalic acid esters, adipic acid esters, phosphoric acid esters, trimellitic acid esters, and citric acid esters; and polymers such as polyethers, polyesters, and polyacetal-based polymers disclosed in JP2013-253227A. When the plasticizer is contained, the contained amount is preferably 1 to 100 parts by mass, more preferably 5 to 50 parts by mass, based on 100 parts by mass of the polymer (A1).

### [Additives]

Particularly, like the plasticizer, as an additive for providing the inventive composition for forming a protective film with filling and planarizing properties, it is preferable to use, for example, liquid additives having polyethylene glycol or polypropylene glycol structures, or thermo-decomposable polymers whose weight reduction ratio on heating from 30°C to 250°C is 40 mass% or more, the polymers having a weight-average molecular weight of 300 to 200,000. The thermo-decomposable polymers preferably contain a repeating unit having an acetal structure shown by the following general formula (DP1) or (DP1a). When the liquid additives or thermo-decomposable polymers are contained, the contained amount is preferably 1 to 100 parts by mass, more preferably 5 to 50 parts by mass, based on 100 parts by mass of the polymer (A1).

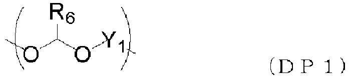

In the formula, R₆ represents a hydrogen atom or a saturated or unsaturated monovalent organic group having 1 to 30 carbon atoms which may be substituted. Y₁ represents a saturated or unsaturated divalent organic group having 2 to 30 carbon atoms.

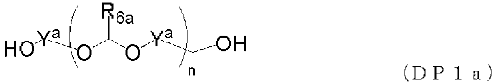

In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### [(G) Colorant]

Furthermore, in the inventive composition for forming a protective film, a colorant (G) can be contained so as to further enhance the resolution upon patterning of the multilayer lithography. The colorant is not particularly limited as long as it is a compound having an appropriate absorbance in the irradiation wavelength, and various known compounds can be widely used. Examples thereof include benzenes, naphthalenes, anthracenes, phenanthrenes, pyrenes, isocyanuric acids, and triazines. When the colorant is contained, the contained amount is preferably 0.01 to 10 parts by mass, more preferably 0.1 to 5 parts by mass, based on 100 parts by mass of the polymer (A1).

Incidentally, it is preferable that the inventive composition for forming a protective film can give a protective film that exhibits resistance to the ammonia-containing aqueous hydrogen peroxide. Such a composition for forming a protective film can form a protective film having favorable resistance to an alkaline aqueous hydrogen peroxide, and therefore, this composition can also be used in a wet etching process using an alkaline aqueous hydrogen peroxide.

The alkaline aqueous hydrogen peroxide is generally used in cleaning of a semiconductor wafer. Especially, a mixture of 5 parts by mass of deionized water, 1 part by mass of 29% by mass of aqueous ammonia solution, and 1 part by mass of 30% by mass of aqueous hydrogen peroxide is called as SC1 (Standard Clean-1); and this mixture is a standard chemical solution for rinsing to remove organic impurities and microparticles on the wafer surface. In addition, using the alkaline aqueous hydrogen peroxide, delamination or etching processing is possible not only for some metals and metal compounds but also for a silicon-containing resist middle layer film that is designed for wet delamination. The composition of the alkaline aqueous hydrogen peroxide used for such processing is not particularly restricted; however, typically, this is a mixture of deionized water, hydrogen peroxide, and ammonia. In this case, the concentration of hydrogen peroxide is preferably 0.1 to 10% by mass, more preferably 0.2 to 5% by mass; and the concentration of ammonia is preferably 0.1 to 10% by mass, more preferably 0.2 to 5% by mass. The temperature in the processing is preferably 0 to 90°C, more preferably 20 to 80°C.

Here, the test of the resistance of the protective film to an alkaline aqueous hydrogen peroxide will be explained. First, under the film formation conditions described later, a film of the composition for forming a protective film is formed on a silicon wafer which has been cut to the size of 3 cm square so as to give the film thickness of about 100 nm. Thereafter, this wafer piece is immersed in a 1.0% by mass aqueous hydrogen peroxide containing 0.5% by mass of ammonia at 70°C for 5 minutes. Subsequently, this is rinsed with deionized water. Thereafter, the protective film is observed visually. By this visual observation, it is possible to examine whether or not the protective film is delaminated from the wafer. When part or all of the protective film is delaminated, thereby exposing the silicon wafer surface, the protective film subjected to the test is judged to be insufficient in resistance to the alkaline aqueous hydrogen peroxide.

Namely, in the protective film formed from the inventive composition for forming a protective film, it is preferable that delamination of the protective film be not observed upon immersing the silicon substrate having the formed protective film in the 1.0% by mass aqueous hydrogen peroxide containing 0.5% by mass of ammonia at 70°C for 5 minutes.

As described above, the inventive composition for forming a protective film can provide a protective film which has excellent resistance to an alkaline aqueous hydrogen peroxide, favorable filling and planarizing properties, and excellent dry-etching properties. Accordingly, the inventive composition for forming a protective film is extremely useful for multilayer resist methods such as a 2-layer resist method, a 3-layer resist method using a silicon-containing resist middle layer film or a silicon-containing inorganic hard mask, and a 4-layer resist method using a silicon-containing resist middle layer film or a silicon-containing inorganic hard mask and an organic antireflective coating. Furthermore, the inventive composition for forming a protective film does not generate by-products even in film formation in an inert gas and has excellent filling and planarizing properties, and therefore, can also be used suitably as a planarizing material in semiconductor device manufacturing processes besides multilayer resist methods. Furthermore, the composition is also extremely useful for patterning processes using wet etching processes.

### <Substrate for Manufacturing Semiconductor Device>

Furthermore, the present invention provides a substrate for manufacturing a semiconductor device, including:
a substrate; and
a protective film which is a cured product of the above-described composition for forming a protective film, formed on the substrate.

A protective film which is a cured product of the inventive composition for forming a protective film has both high filling and planarizing properties, and thus, does not have fine vacancies due to insufficient filling or unevenness of the protective film surface due to insufficient planarization. A substrate for manufacturing a semiconductor device planarized with such a protective film has a wide process margin at the time of patterning, and a semiconductor device can be manufactured with a good yield. Furthermore, the substrate for manufacturing a semiconductor device includes a protective film having excellent resistance to an alkaline aqueous hydrogen peroxide, and therefore, is also provided with high compatibility to wet etching processes.

### <Method for Forming Protective Film>

Furthermore, the present invention provides a method for forming a protective film to be used in a process of manufacturing a semiconductor device, the method including:
spin-coating a substrate to be processed with the above-described composition for forming a protective film to obtain a coating film; and
curing the coating film by heating at a temperature of 100°C or higher and 600°C or lower for 10 to 600 seconds to obtain a cured film.

In this method for forming a protective film, firstly, the inventive composition for forming a protective film described above is applied onto a substrate to be processed by spin-coating. By employing a spin-coating method, a favorable filling property can be achieved. After spin-coating, baking (heating) is performed to promote planarization by thermal flow and promote a crosslinking reaction. Incidentally, the organic solvent in the composition for forming a protective film can be evaporated by the baking, and therefore, mixing can be prevented even when a resist upper layer film, a silicon-containing resist middle layer film, etc. is formed on the protective film.

A protective film to be applied to a process of manufacturing a semiconductor device formed by the inventive method for forming a protective film has high filling and planarizing properties, and therefore, when used in a process of manufacturing a semiconductor device, a semiconductor device can be manufactured with a good yield.

In the step of forming a film by heating for forming a protective film, one-stage baking, two-stage baking, or multistage baking of three or more stages can be adopted, and one-stage baking or two-stage baking is preferable economically. The film formation by the one-stage baking is performed, for example, at a temperature of 100°C or higher and 600°C or lower for 5 to 600 seconds, preferably 150°C or higher and 500°C or lower for 10 to 600 seconds. By heating under such conditions, planarization by thermal flow and a crosslinking reaction can be promoted. In a multilayer resist method, a coating-type silicon middle layer film or a CVD hard mask may be formed on the obtained film in some cases. In a case where a coating-type silicon middle layer film is adopted, the film is preferably formed at a temperature higher than the temperature at which the silicon middle layer film is formed. Generally, a silicon middle layer film is formed at 100°C or higher and 400°C or lower, preferably 150°C or higher and 350°C or lower. When the protective film is formed at a temperature higher than this temperature, dissolution of the protective film due to the composition for forming a silicon middle layer film can be prevented, and it is possible to form a protective film that does not mix with the composition.

In a case where a CVD hard mask is adopted, the protective film is preferably formed at a temperature higher than the temperature at which the CVD hard mask is formed. The temperature at which to form the CVD hard mask can be, for example, 150°C or higher and 500°C or lower.

Meanwhile, in the film formation by the two-stage baking, the first baking is performed in such a manner that the upper limit of the treatment temperature is, for example, 300°C or lower in air, preferably 250°C or lower for 10 to 600 seconds, considering the influence of corrosion of the substrate due to the oxygen in the air. The baking temperature in the second stage is higher than the baking temperature in the first stage. The second baking is preferably performed at a temperature of 600°C or lower, preferably 500°C or lower for 10 to 7200 seconds. In a multilayer resist method, a coating-type silicon middle layer film or a CVD hard mask is formed on the obtained film in some cases. When a coating-type silicon middle layer film is to be applied, the protective film is preferably formed at a higher temperature than the temperature at which the silicon middle layer film is formed. Generally, a silicon middle layer film is formed at 100°C or higher and 400°C or lower, preferably 150°C or higher and 350°C or lower. When the protective film is formed at a temperature higher than this temperature, dissolution of the protective film by the composition for forming a silicon middle layer film can be prevented, and a protective film that does not mix with the composition can be formed.

In a case where a CVD hard mask is adopted in two-stage baking, the protective film is preferably formed at a temperature higher than the temperature at which the CVD hard mask is formed. The temperature at which to form the CVD hard mask can be, for example, 150°C or higher and 500°C or lower.

Furthermore, in the present invention, it is possible to heat a substrate to be processed in an atmosphere having an oxygen concentration of 1% or less, for example, to prevent corrosion of the substrate to be processed.

In this method for forming a protective film, for example, firstly, the inventive composition for forming a protective film described above is applied onto a substrate to be processed by spin-coating. After the spin-coating, in the two-stage baking, baking is first performed in air at 300°C or lower, and then the second baking is performed in an atmosphere having an oxygen concentration of 1% or less. In the one-stage baking, the first baking in air performed first can be skipped. Incidentally, examples of the atmosphere during baking include inert gases such as nitrogen, argon, and helium. The inventive composition for forming a protective film makes it possible to form a sufficiently cured protective film without generating a sublimation product even when baked in such an inert gas atmosphere.

Furthermore, in the inventive method for forming a protective film, a substrate to be processed having a structure or step having a height of 30 nm or more can be used. As described above, the inventive composition for forming a protective film is excellent in filling and planarizing properties, and therefore, a flat cured film can be formed even when the substrate to be processed has a structure or step (unevenness) having a height of 30 nm or more. That is, the inventive method for forming a protective film is particularly useful when forming a flat protective film on such a substrate to be processed.

Incidentally, the thickness of the formed protective film is appropriately selected, and is preferably 30 to 20,000 nm, particularly preferably 50 to 15,000 nm.

In addition, the above-described method for forming a protective film is applicable for both a case where protective film for patterning is formed using the inventive composition for forming a protective film and a case where a protective film for a planarizing film is formed.

A protective film, formed by the inventive method, to be applied to a process of manufacturing a semiconductor device has high resistance to an alkaline aqueous hydrogen peroxide, high filling and planarizing properties, and excellent dry-etching properties, and when used in a process of manufacturing a semiconductor device, the semiconductor device can be manufactured with a good yield.

### <Patterning Process>

### [2-Layer Resist Process]

The present invention provides a patterning process for forming a pattern in a substrate to be processed, including the steps of:
(I-1) forming a protective film on a substrate to be processed by using the inventive composition for forming a protective film;
(I-2) forming a resist upper layer film on the protective film by using a photoresist material;
(I-3) forming a circuit pattern in the resist upper layer film; and
(I-4) transferring the pattern to the protective film by etching while using the resist upper layer film having the formed pattern as a mask.

In a process of manufacturing a semiconductor device, the semiconductor device can be manufactured with a good yield when the circuit pattern is formed by such a patterning process, being an example of the present invention. Furthermore, a protective film formed using the inventive composition for forming a protective film as described above has favorable resistance to an alkaline aqueous hydrogen peroxide, and therefore, is also applicable to wet etching processes using alkaline aqueous hydrogen peroxides.

### [3-Layer Resist Method Using Silicon-Containing Resist Middle Layer Film]

The present invention also provides a patterning process for forming a pattern in a substrate to be processed, including the steps of:
(II-1) forming a protective film on a substrate to be processed by using the inventive composition for forming a protective film;
(II-2) forming a silicon-containing resist middle layer film on the protective film by using a silicon-containing resist middle layer film material;
(II-3) forming a resist upper layer film on the silicon-containing resist middle layer film by using a photoresist composition;
(II-4) forming a circuit pattern in the resist upper layer film;
(II-5) transferring the pattern to the silicon-containing resist middle layer film by etching while using the resist upper layer film having the formed pattern as a mask;
(II-6) transferring the pattern to the protective film by etching while using the silicon-containing resist middle layer film having the transferred pattern as a mask; and
(II-7) forming the pattern in the substrate to be processed while using the protective film having the transferred pattern as a mask.

The inventive patterning process will be described in the following with reference to an example of a 3-layer resist process using a resist middle layer film containing silicon atoms (silicon-containing resist middle layer film), but is not limited thereto.

The substrate to be processed is preferably a semiconductor device substrate or the semiconductor device substrate coated with any of a metal film, a metal carbide film, a metal oxide film, a metal nitride film, a metal oxycarbide film, and a metal oxynitride film. The substrate to be processed is not particularly limited, but more specifically, it is possible to use substrates made of Si, α-Si, p-Si, SiO₂, SiN, SiON, W, TiN, Al, or the like; the substrate coated with the metal film or the like as a layer to be processed; etc.

Examples of the layer to be processed include: various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, in particular, 100 to 5,000 nm. Note that when the layer to be processed is formed, the substrate and the layer to be processed are formed from different materials.

Note that the metal constituting the substrate to be processed is preferably silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

Furthermore, as the substrate to be processed, a substrate to be processed having a structure or step with a height of 30 nm or more is preferably used.

When a protective film is formed on a substrate to be processed by using the inventive composition for forming a protective film, the inventive method for forming a protective film described above can be applied.

Next, a resist middle layer film (silicon-containing resist middle layer film) is formed on the protective film by using a resist middle layer film material containing silicon atoms. As the silicon-containing resist middle layer film material, a polysiloxane-based middle layer film material is preferable. By providing the silicon-containing resist middle layer film with an antireflective effect, reflection can be suppressed. Particularly, for 193-nm light exposure, a material containing many aromatic groups and having high etching selectivity to a substrate is used as a composition for forming a protective film, so that the k-value and thus the substrate reflection are increased. However, the reflection can be suppressed by providing the silicon-containing resist middle layer film with absorption to achieve an appropriate k-value. Thus, the substrate reflection can be reduced to 0.5% or less. As the silicon-containing resist middle layer film having the antireflective effect, a polysiloxane is preferably used, the polysiloxane having anthracene for 248-nm and 157-nm light exposure, or a phenyl group or a light-absorbing group having a silicon-silicon bond for 193-nm light exposure in a pendant structure or in the polysiloxane structure, and being crosslinked by an acid or heat.

Next, a resist upper layer film is formed on the silicon-containing resist middle layer film by using a resist upper layer film material containing a photoresist composition. The resist upper layer film material may be a positive type or a negative type, and any generally-used photoresist composition can be employed. After the spin-coating with the resist upper layer film material, it is preferable to perform prebaking at 60 to 180°C for 10 to 300 seconds. Then, light exposure, post-exposure baking (PEB), and development are performed according to conventional methods to obtain the resist upper layer film pattern. Note that the thickness of the resist upper layer film is not particularly limited, but is preferably 30 to 500 nm, and particularly preferably 50 to 400 nm.

Next, a circuit pattern (resist upper layer film pattern) is formed in the resist upper layer film. The circuit pattern is preferably formed by a lithography using light with a wavelength of 10 nm or more to 300 nm or less, a direct drawing with electron beam, nanoimprinting, or a combination thereof.

Note that examples of the exposure light include high-energy beam with a wavelength of 300 nm or less; specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) with a wavelength of 3 to 20 nm, electron beam (EB), ion beam, X-ray, and the like.

Additionally, in forming the circuit pattern, the circuit pattern is preferably developed by alkali development or development with an organic solvent.

Next, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed using a fluorocarbon-based gas. Thereby, a silicon-containing resist middle layer film pattern is formed.

Next, the pattern is transferred to the protective film by etching while using the silicon-containing resist middle layer film having the transferred pattern as a mask. Since the silicon-containing resist middle layer film exhibits higher etching resistance to an oxygen gas or a hydrogen gas than an organic material, the etching of the protective film performed while using the silicon-containing resist middle layer film pattern as a mask is preferably performed using an etching gas mainly containing an oxygen gas or a hydrogen gas. Thereby, a protective film pattern can be formed.

Next, a pattern is formed in the substrate to be processed while using the protective film having the transferred pattern as a mask. For example, the pattern is transferred to the substrate to be processed by etching while using the protective film having the transferred pattern as a mask. The subsequent etching of the substrate to be processed (layer to be processed) can be performed according to a conventional method. For example, the substrate to be processed made of SiO₂, SiN, or silica-based low-dielectric insulating film is etched mainly with a fluorocarbon-based gas. The substrate to be processed made of p-Si, Al, or W is etched mainly with a chlorine- or bromine-based gas. When the substrate is processed by etching with a fluorocarbon-based gas, the silicon-containing resist middle layer film pattern is removed together with the substrate processing. Meanwhile, when the substrate is processed by etching with a chlorine- or bromine-based gas, the silicon-containing resist middle layer film pattern needs to be removed by additional dry etching with a fluorocarbon-based gas after the substrate processing.

The protective film obtained using the inventive composition for forming a protective film can exhibit excellent etching resistance when the substrate to be processed is etched as described above.

### [4-Layer Resist Method Using Inorganic Hard Mask and Organic Antireflective Coating]

The present invention also provides a patterning process for forming a pattern in a substrate to be processed, including the steps of:
(III-1) forming a protective film on a substrate to be processed by using the inventive composition for forming a protective film;
(III-2) forming an inorganic hard mask selected from the group consisting of a silicon oxide film, a silicon nitride film, a silicon oxynitride film, a titanium oxide film, and a titanium nitride film on the protective film;
(III-3) forming an organic antireflective coating on the inorganic hard mask;
(III-4) forming a resist upper layer film on the organic antireflective coating by using a photoresist composition, so that a 4-layered film structure is constructed, and forming a circuit pattern in the resist upper layer film;
(III-5) transferring the pattern to the organic antireflective coating and the inorganic hard mask by etching while using the resist upper layer film having the formed pattern as a mask;
(III-6) transferring the pattern to the protective film by etching while using the inorganic hard mask having the transferred pattern as a mask; and
(III-7) forming the pattern in the substrate to be processed while using the protective film having the transferred pattern as a mask.

The organic antireflective coating can be formed by spin-coating using a known organic antireflective coating material.

The inorganic hard mask selected from the group consisting of a silicon oxide film, a silicon nitride film, and a silicon oxynitride film (SiON film) can be formed, for example, by a CVD method, an ALD method, etc. The method for forming the silicon nitride film is disclosed in, for example, JP2002-334869A, WO2004/066377A1, etc. The film thickness of the inorganic hard mask is preferably 5 to 200 nm, more preferably 10 to 100 nm. As the inorganic hard mask, a SiON film is most preferably used, being effective as an antireflective coating. When the SiON film is formed, the substrate temperature reaches 300 to 500°C. Hence, a protective film as an underlayer film needs to withstand the temperature of 300 to 500°C. The protective film formed using the inventive composition for forming a protective film has high heat resistance and can withstand high temperatures of 300°C to 500°C, and this enables the combination of the inorganic hard mask formed by a CVD method or an ALD method with the protective film formed by a spin-coating method.

Particularly, when the SiON film is used as the inorganic hard mask, two layers of antireflective coating including the SiON film and the BARC make it possible to suppress the reflection even in liquid immersion exposure at a high NA exceeding 1.0. Another merit of the BARC formation is having an effect of reducing footing of the resist upper layer film pattern immediately above the SiON film.

Herein, FIG. 2 (A) to (F) show an example of the inventive patterning process according to the 3-layer resist method. In the 3-layer resist method, for example, as shown in FIG. 2 (A), a protective film 3 is formed by using the inventive composition for forming a protective film on a layer 2 to be processed formed on a substrate 1. Then, a silicon-containing resist middle layer film 4 is formed, and a resist upper layer film 5 is formed thereon. Subsequently, as shown in FIG. 2 (B), an exposure portion 6 of the resist upper layer film 5 is exposed to light, followed by PEB (post-exposure bake). Thereafter, as shown in FIG. 2 (C), a resist upper layer film pattern 5a is formed by development. After that, the silicon-containing resist middle layer film 4 is processed by dry-etching using a fluorocarbon-based gas while using the resist upper layer film pattern 5a as a mask. Thereby, a silicon-containing resist middle layer film pattern 4a is formed as shown in FIG. 2 (D). Then, after the resist upper layer film pattern 5a is removed, the protective film 3 is etched with oxygen plasma while using the silicon-containing resist middle layer film pattern 4a as a mask. Thereby, a protective film pattern 3a is formed as shown in FIG. 2 (E). Further, after the silicon-containing resist middle layer film pattern 4a is removed, the layer 2 to be processed is processed by etching while using the protective film pattern 3a as a mask. Thus, a pattern 2a is formed as shown in FIG. 2 (F).

In the case where an inorganic hard mask is formed, the silicon-containing resist middle layer film 4 may be replaced with the inorganic hard mask. In the case where a BARC is formed, the BARC may be formed between the silicon-containing resist middle layer film 4 and the resist upper layer film 5. The BARC may be etched continuously and before the etching of the silicon-containing resist middle layer film 4. Alternatively, after the BARC is etched alone, the silicon-containing resist middle layer film 4 may be etched, for example, after an etching apparatus is changed.

### (Special Manufacturing Process)

Furthermore, when the inventive patterning processes are applied, various special manufacturing processes can be constructed in addition to general manufacturing processes as described above; and thus, the inventive patterning process has a high value in industry. In the following, some embodiments of special manufacturing processes will be described.

### (First Embodiment)

Firstly, with regard to the removal of the silicon-containing resist middle layer film, generally, delamination by the dry etching is imperative as mentioned above; however, in the inventive patterning process, because the protective film has excellent resistance to an alkaline aqueous hydrogen peroxide, wet delamination of only the silicon-containing resist middle layer film by using the alkaline aqueous hydrogen peroxide can also be chosen. Namely, in the inventive patterning process of the 3-layer resist process, a step of removing the silicon-containing resist middle layer film having the transferred pattern by the wet etching using the alkaline aqueous hydrogen peroxide may be further added after the step (II-6) described above.

### (Second Embodiment)

Further, in a case where the substrate to be processed is W, TiN, or the like, when the inventive patterning process is used, the wet etching processing of the substrate by using the alkaline aqueous hydrogen peroxide can also be chosen. Namely, in the inventive patterning processes of the 2-layer, 3-layer, and 4-layer resist processes, a step of transferring the pattern to the substrate to be processed by the wet etching using the alkaline aqueous hydrogen peroxide while using the protective film having the transferred pattern as a mask may be included after the step (I-4), the step (II-7), or the step (III-7) described above.

In an example of the process according to a 2-layer resist process, firstly, a protective film is formed on a substrate to be processed, and then a resist upper layer film is formed on the protective film. Subsequently, the resist upper layer film is patterned by a conventional method, followed by etching to transfer the pattern to the protective film. Finally, the substrate to be processed can be patterned by wet etching while using the protective film as a mask.

In an example of the process according to a 3-layer or 4-layer resist process, firstly, a protective film is formed on a substrate to be processed, a silicon-containing resist middle layer film is formed thereon as necessary, and then a resist upper layer film is formed on the protective film or on the silicon-containing resist middle layer film. Subsequently, the resist upper layer film is patterned by a conventional method, followed by etching to transfer the pattern to the protective film. Finally, the substrate to be processed can be patterned by wet etching while using the protective film as a mask.

### (Third Embodiment)

Meanwhile, in the inventive patterning process of the 2-layer, 3-layer, or 4-layer resist process, a step of pattern-processing the substrate to be processed by implanting ions while using the protective film having the transferred pattern as a mask may be included after the step (I-4), the step (II-7), or the step (III-7). In this case, after the step of pattern-processing the substrate to be processed by implanting ions, a step of removing the silicon-containing resist middle layer film having the transferred pattern may be further added, the removal being carried out by wet etching using an alkaline aqueous hydrogen peroxide.

The inventive patterning process is also suitable for processing of a stepped substrate having a structure or step having a height of 30 nm or more. In the following, an example of such a process will be described.

Firstly, a protective film is formed on a stepped substrate to carry out filling and planarization, a silicon-containing resist middle layer film is formed as necessary, and then a resist upper layer film is formed on the protective film or on the silicon-containing resist middle layer film. Subsequently, the resist upper layer film is patterned by a conventional method, followed by etching to transfer the pattern to the protective film. Subsequently, the substrate can be pattern-processed by ion implantation while using the protective film as a mask. The remaining silicon-containing resist middle layer film can be removed by either dry etching or wet etching as necessary. Finally, the protective film can be removed by dry etching.

As described above, the inventive patterning processes make it possible to precisely form a fine pattern in a substrate to be processed by the multilayer resist methods.

### EXAMPLES

Hereinafter, the present invention will be more specifically described with reference to Synthesis Examples, Comparative Synthesis Examples, Examples, and Comparative Examples. However, the present invention is not limited thereto. Note that, with respect to molecular weight and dispersity, weight-average molecular weight (Mw) and number-average molecular weight (Mn) were measured by gel permeation chromatography (GPC) using tetrahydrofuran as an eluent in terms of polystyrene, and dispersity (Mw/Mn) was calculated therefrom.

### Synthesis Example 1: Synthesis of Polymers for Compositions for Forming Protective Film

For the synthesis of polymers (A1-1) to (A1-8) for compositions for forming a protective film, one of the diepoxy compounds (a-1) to (a-4), one of the dicarboxylic acids (b-1) to (b-8), and, as an epoxy compound to be an end-capping agent, (c-1) shown below were each used.

### Diepoxy compounds:

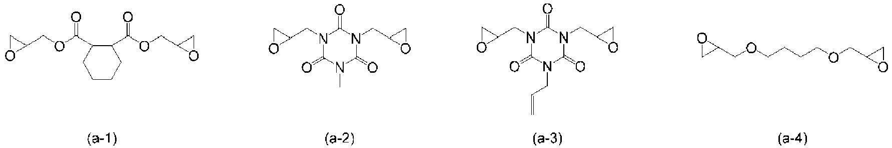

### Dicarboxylic acids:

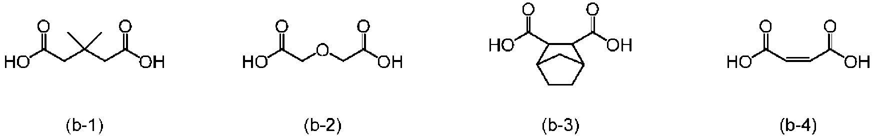

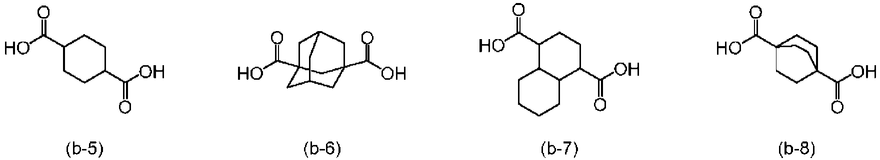

### End-capping agent:

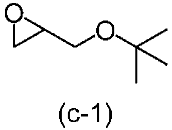

### [Synthesis Example 1-1] Synthesis of Polymer (A1-1)

8.53 g of the diepoxy compound (a-1), 7.21 g of the dicarboxylic acid (b-1), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-1). When the weight-average molecular weight (Mw) and dispersity (Mw/Mn) were measured by GPC, the following results were obtained. 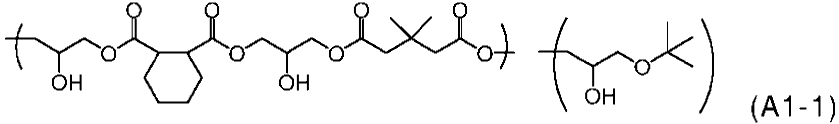 (A1-1): Mw=2050, Mw/Mn=1.57

### [Synthesis Example 1-2] Synthesis of Polymer (A1-2)

8.53 g of the diepoxy compound (a-1), 6.03 g of the dicarboxylic acid (b-2), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-2). When the weight-average molecular weight (Mw) and dispersity (Mw/Mn) were measured by GPC, the following results were obtained. 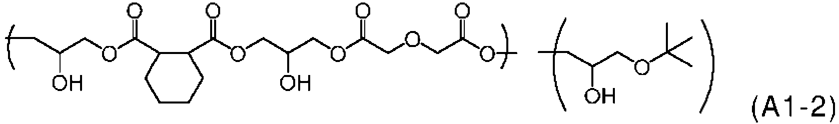 (A1-2): Mw=2010, Mw/Mn=1.63

### [Synthesis Example 1-3] Synthesis of Polymer (A1-3)

7.66 g of the diepoxy compound (a-2), 8.29 g of the dicarboxylic acid (b-3), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-3). When the weight-average molecular weight (Mw) and dispersity (Mw/Mn) were measured by GPC, the following results were obtained. 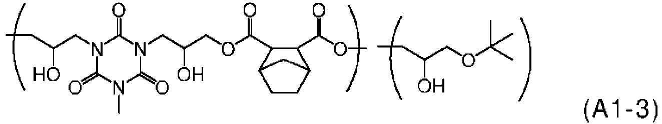 (A1-3): Mw=2430, Mw/Mn=1.59

### [Synthesis Example 1-4] Synthesis of Polymer (A1-4)

7.66 g of the diepoxy compound (a-2), 5.22 g of the dicarboxylic acid (b-4), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-4). When the weight-average molecular weight (Mw) and dispersity (Mw/Mn) were measured by GPC, the following results were obtained. 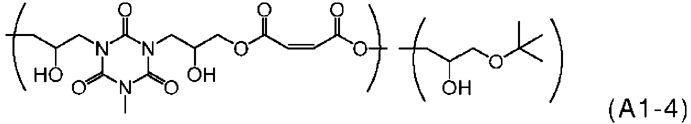 (A1-4): Mw=2550, Mw/Mn=1.71

### [Synthesis Example 1-5] Synthesis of Polymer (A1-5)

8.44 g of the diepoxy compound (a-3), 7.75 g of the dicarboxylic acid (b-5), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-5). When the weight-average molecular weight (Mw) and dispersity (Mw/Mn) were measured by GPC, the following results were obtained. 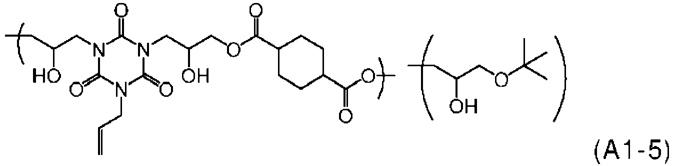 (A1-5): Mw=2720, Mw/Mn=1.64

### [Synthesis Example 1-6] Synthesis of Polymer (A1-6)

8.44 g of the diepoxy compound (a-3), 10.09 g of the dicarboxylic acid (b-6), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-6). When the weight-average molecular weight (Mw) and dispersity (Mw/Mn) were measured by GPC, the following results were obtained. 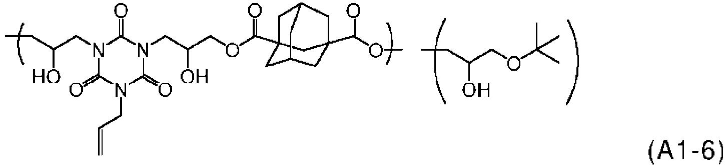 (A1-6): Mw=2870, Mw/Mn=1.74

### [Synthesis Example 1-7] Synthesis of Polymer (A1-7)

6.07 g of the diepoxy compound (a-4), 10.18 g of the dicarboxylic acid (b-7), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-7). When the weight-average molecular weight (Mw) and dispersity (Mw/Mn) were measured by GPC, the following results were obtained. 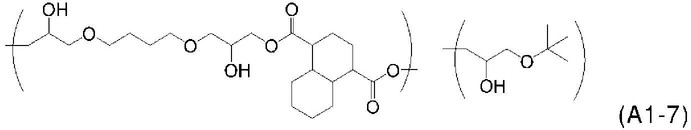 (A1-7): Mw=1990, Mw/Mn=1.61

### [Synthesis Example 1-8] Synthesis of Polymer (A1-8)

6.07 g of the diepoxy compound (a-4), 8.92 g of the dicarboxylic acid (b-8), and 100 g of 2-methoxy-1-propanol were mixed under a nitrogen atmosphere at a solution temperature of 100°C to form a homogeneous solution. To this homogeneous solution, 1.02 g of benzyltriethylammonium chloride was added, and the mixture was stirred at an inner temperature of 120°C for 2 hours. To the reaction solution, 3.90 g of the end-capping agent (c-1) was added, and the mixture was further stirred at an inner temperature of 120°C for 8 hours. The reaction solution was cooled to room temperature, and then 200 g of methyl isobutyl ketone was added thereto. The organic layer was washed twice with 100 g of a 3% aqueous solution of nitric acid, and then further washed six times with 100 g of pure water. The organic layer was evaporated under reduced pressure to dryness to obtain a polymer (A1-8). When the weight-average molecular weight (Mw) and dispersity (Mw/Mn) were measured by GPC, the following results were obtained. 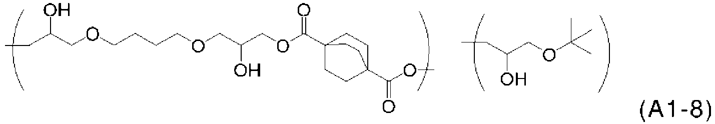 (A1-8): Mw=2120, Mw/Mn=1.67

### Synthesis Example 2: Synthesis of Additional Polymers

For the synthesis of additional polymers (A2-1) and (A2-2) for compositions for forming a protective film, the (meth)acrylate compounds (d-1) to (d-4) shown below were used.

### (Meth)acrylate compounds:

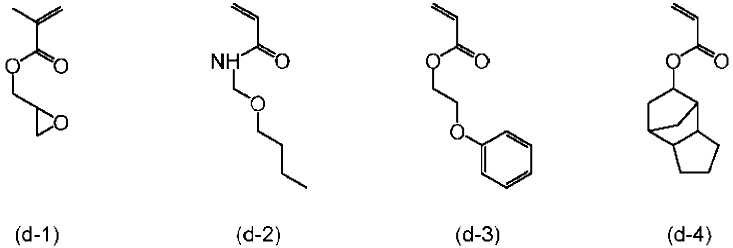

### [Synthesis Example 2-1] Synthesis of Polymer (A2-1)

23.3 g of PGMEA was heated and stirred at 80°C under a nitrogen atmosphere. A mixture of 25.8 g of the methacrylate compound (d-1), 28.5 g of the acrylate compound (d-2), and 46.7 g of PGMEA and a mixture of 4.45 g of dimethyl 2,2-azobis(2-methylpropionate) and 46.7 g of PGMEA were added thereto simultaneously, so that each mixture was added separately, over 2 hours. The obtained mixture was further heated and stirred for 16 hours, and then cooled to 60°C. Subsequently, 200 g of heptane was added thereto, and then the mixture was cooled to room temperature and left to stand for 2 hours. The upper layer was removed by separation, 100 g of PGMEA was added, and then the heptane was distilled off under reduced pressure to obtain a solution of the target polymer (A2-1) in PGMEA. When the weight-average molecular weight (Mw) and dispersity (Mw/Mn) were measured by GPC, the following results were obtained. 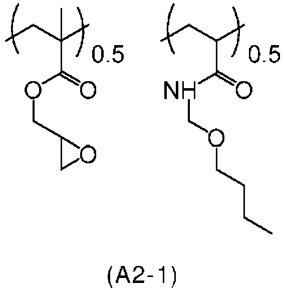 (A2-1): Mw=5070, Mw/Mn=1.82

### [Synthesis Example 2-2] Synthesis of Polymer (A2-2)

23.3 g of PGMEA was heated and stirred at 80°C under a nitrogen atmosphere. A mixture of 25.8 g of the methacrylate compound (d-1), 12.0 g of the acrylate compound (d-3), 12.9 g of the acrylate compound (d-4), and 46.7 g of PGMEA and a mixture of 4.45 g of dimethyl 2,2-azobis(2-methylpropionate) and 46.7 g of PGMEA were added thereto simultaneously, so that each mixture was added separately, over 2 hours. The obtained mixture was further heated and stirred for 16 hours, and then cooled to 60°C. Subsequently, 200 g of heptane was added thereto, and then the mixture was cooled to room temperature and left to stand for 2 hours. The upper layer was removed by separation, 100 g of PGMEA was added, and then the heptane was distilled off under reduced pressure to obtain a solution of the target polymer (A2-2) in PGMEA. When the weight-average molecular weight (Mw) and dispersity (Mw/Mn) were measured by GPC, the following results were obtained. 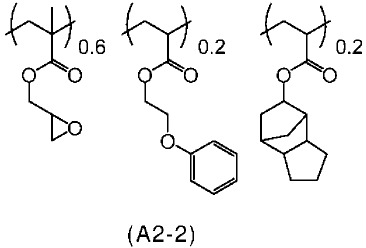 (A2-2): Mw=7700, Mw/Mn=1.90

### Comparative Synthesis Example: Synthesis of Comparative Compound and Polymers

For the synthesis of a compound (R1) and polymers (R2) to (R4) for Comparative Examples, the compounds (r-1) to (r-7) shown below were used.

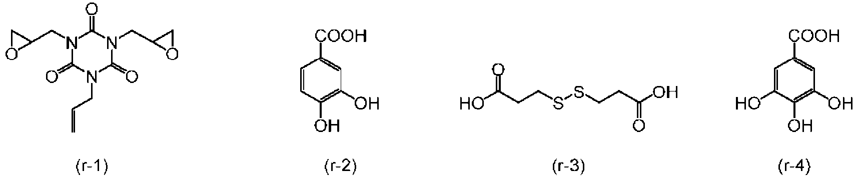

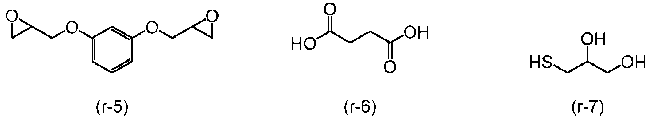

### [Comparative Synthesis Example 1] Synthesis of Compound (R-1)

45.5 g of the diepoxy compound (r-1), 54.5 g of the carboxylic acid (r-2), and 300 g of 2-methoxy-1-propanol were mixed under a nitrogen atmosphere at a solution temperature of 100°C to form a homogeneous solution. To this homogeneous solution, 10.0 g of benzyltriethylammonium chloride was added, and the mixture was stirred at a solution temperature of 120°C for 12 hours. The mixture was cooled to room temperature, and then 1,000 g of methyl isobutyl ketone was added thereto. The organic layer was washed five times with 200 g of pure water. The organic layer was evaporated under reduced pressure to dryness to obtain a compound (R-1). When the weight-average molecular weight (Mw) and dispersity (Mw/Mn) were measured by GPC, the following results were obtained. 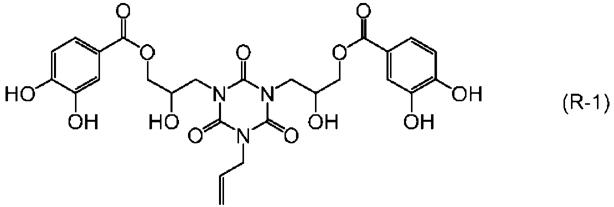 (R-1): Mw=780, Mw/Mn=1.04

### [Comparative Synthesis Example 2] Synthesis of Polymer (R-2)

20.0 g of the diepoxy compound (r-1), 16.4 g of the dicarboxylic acid (r-3), and, as a catalyst, 0.66 g of ethyltriphenylphosphonium bromide were dissolved in 92.7 g of propylene glycol monomethyl ether, and then stirred at 105°C for 24 hours. The mixture was cooled to room temperature, and then 1,000 g of methyl isobutyl ketone was added thereto. The organic layer was washed five times with 200 g of pure water. The organic layer was evaporated under reduced pressure to dryness to obtain a polymer (R-2). When the weight-average molecular weight (Mw) and dispersity (Mw/Mn) were measured by GPC, the following results were obtained. 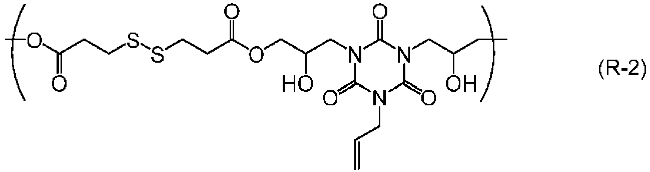 (R-2): Mw=4600, Mw/Mn=2.02

### [Comparative Synthesis Example 3] Synthesis of Polymer (R-3)

20.0 g of the diepoxy compound (r-1), 12.7 g of the dicarboxylic acid (r-3), 4.22 g of a monohydrate of the carboxylic acid (r-4), and, as a catalyst, 1.81 g of tetrabutylphosphonium bromide were dissolved in 58.1 g of propylene glycol monomethyl ether, and then stirred at 105°C for 12 hours. The mixture was cooled to room temperature, and then 1,000 g of methyl isobutyl ketone was added thereto. The organic layer was washed five times with 200 g of pure water. The organic layer was evaporated under reduced pressure to dryness to obtain a polymer (R-3). When the weight-average molecular weight (Mw) and dispersity (Mw/Mn) were measured by GPC, the following results were obtained. 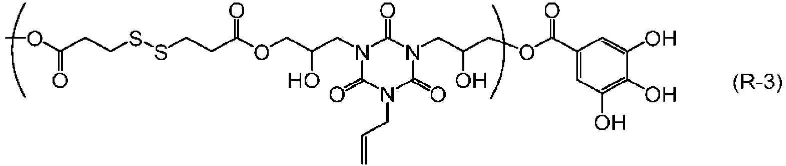 (R-3): Mw=3100, Mw/Mn=1.73

### [Comparative Synthesis Example 4] Synthesis of Polymer (R-4)

59.8 g of the diepoxy compound (r-5), 14.0 g of the dicarboxylic acid (r-6), 2.85 g of the thiol (r-7), and, as a catalyst, 3.35 g of tetrabutylphosphonium bromide were dissolved in 320 g of propylene glycol monomethyl ether, and then stirred at 100°C for 24 hours. The mixture was cooled to room temperature, and then 1,000 g of methyl isobutyl ketone was added thereto. The organic layer was washed five times with 200 g of pure water. The organic layer was evaporated under reduced pressure to dryness to obtain a polymer (R-4). When the weight-average molecular weight (Mw) and dispersity (Mw/Mn) were measured by GPC, the following results were obtained. 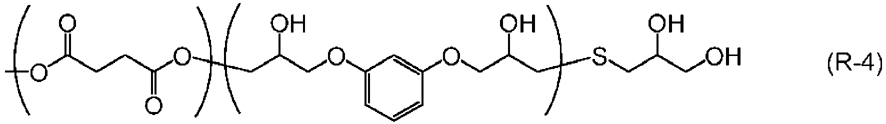 (R-4): Mw=4772, Mw/Mn=1.98

### Preparation of Compositions (UDL-1 to -12, Comparative UDL-1 to -4) for Forming Protective Film

One of the polymers (A1-1) to (A1-8), compound (R-1), and polymers (R-2) to (R-4) synthesized in the above-described manner, the additional polymer (A2-1) or (A2-2) synthesized in the above-described manner, and, as an acid generator, (F-1) CF₃CF₂CF₂CF₂SO₃⁻(CH₃CH₂)₃N⁺H or (F-2) pyridinium trifluoromethanesulfonate were dissolved in the proportions shown in Table 1 by using propylene glycol monomethyl ether acetate (PGMEA) containing 0.1% by mass of FC-4430 (manufactured by Sumitomo 3M Ltd.), and then filtered through a 0.1-µm filter made of a fluorinated resin. Thus, each composition (UDL-1 to -9, comparative UDL-1 to -4) for forming a protective film was prepared. In addition, UDL-10 to -12 were prepared in the same manner as UDL-3, UDL-5, and UDL-7, except that (S1) 1,6-diacetoxyhexane, having a boiling point of 260°C, (S2) diethylene glycol monobenzyl ether, having a boiling point of 311°C, and (S3) tripropylene glycol monomethyl ether, having a boiling point of 242°C, as high-boiling-point solvents, were used in the proportions shown below in Table 1.

**[Table 1]**

| Composition for forming protective film | Polymer (A1) (parts by mass) | Polymer (A2) (parts by mass) | Acid Generator (parts by mass) | High-boiling-point Solvent (parts by mass) | Solvent (parts by mass) |
|---|---|---|---|---|---|
| UDL-1 | A1-1 (8) | A2-1 (2) | F-1 (0.5) | - | PGMEA (90) |
| UDL-2 | A1-2 (8) | A2-1 (2) | F-1 (0.5) | - | PGMEA (90) |
| UDL-3 | A1-3 (8) | A2-1 (2) | F-1 (0.5) | - | PGMEA (90) |
| UDL-4 | A1-4 (8) | A2-1 (2) | F-1 (0.5) | - | PGMEA (90) |
| UDL-5 | A1-5 (8) | A2-1 (2) | F-1 (0.5) | - | PGMEA (90) |
| UDL-6 | A1-6 (8) | A2-1 (2) | F-1 (0.5) | - | PGMEA (90) |
| UDL-7 | A1-7 (8) | A2-1 (2) | F-1 (0.5) | - | PGMEA (90) |
| UDL-8 | A1-8 (8) | A2-1 (2) | F-1 (0.5) | - | PGMEA (90) |
| UDL-9 | A1-1 (8) | A2-2 (2) | F-1 (0.5) | - | PGMEA (90) |
| UDL-10 | A1-3 (8) | A2-1 (2) | F-1 (0.5) | S1 (10) | PGMEA (80) |
| UDL-11 | A1-5 (8) | A2-1 (2) | F-1 (0.5) | S2 (10) | PGMEA (80) |
| UDL-12 | A1-7 (8) | A2-1 (2) | F-1 (0.5) | S3 (10) | PGMEA (80) |
| Comparative UDL-1 | R-1 (8) | A2-1 (2) | F-1 (0.5) | - | PGMEA (90) |
| Comparative UDL-2 | R-2 (8) | A2-1 (2) | F-2 (0.5) | - | PGMEA (90) |
| Comparative UDL-3 | R-3 (8) | A2-1 (2) | F-2 (0.5) | - | PGMEA (90) |
| Comparative UDL-4 | R-4 (8) | A2-1 (2) | F-2 (0.5) | - | PGMEA (90) |

### Example 1: Solvent Resistance Measurement (Examples 1-1 to 1-12, Comparative Examples 1-1 to 1-4)

Each of the compositions (UDL-1 to -12, comparative UDL-1 to -4) for forming a protective film prepared above was respectively applied onto a silicon substrate, and the coating film was cured by baking in air at 250°C for 60 seconds. The film thickness "a" [Å] of each cured product (protective film) thus obtained was measured. Subsequently, a PGMEA solvent was dispensed on each protective film and allowed to stand for 30 seconds. The resultant was spin-dried and baked at 100°C for 60 seconds to evaporate the PGMEA solvent. The film thickness "b" [Å] of each protective film after the evaporation was measured again. The difference between the film thicknesses of before and after the PGMEA treatment was calculated from the film thicknesses "a" and "b" thus measured to evaluate solvent resistance. The results are shown in Table 2.

**[Table 2]**

| | Composition for forming protective film | Film Thickness after film formation: a (Å) | Film Thickness after PGMEA treatment: b (Å) | b/a × 100 (%) |
|---|---|---|---|---|
| Example 1-1 | UDL-1 | 2006 | 2003 | 99.9 |
| Example 1-2 | UDL-2 | 1991 | 1990 | 99.9 |
| Example 1-3 | UDL-3 | 2004 | 1999 | 99.8 |
| Example 1-4 | UDL-4 | 1999 | 1997 | 99.9 |
| Example 1-5 | UDL-5 | 2007 | 2003 | 99.8 |
| Example 1-6 | UDL-6 | 1998 | 1996 | 99.9 |
| Example 1-7 | UDL-7 | 2000 | 1998 | 99.9 |
| Example 1-8 | UDL-8 | 1992 | 1989 | 99.8 |
| Example 1-9 | UDL-9 | 2000 | 1997 | 99.9 |
| Example 1-10 | UDL-10 | 2005 | 2001 | 99.8 |
| Example 1-11 | UDL-11 | 1999 | 1997 | 99.9 |
| Example 1-12 | UDL-12 | 2006 | 2004 | 99.9 |
| Comparative Example 1-1 | Comparative UDL-1 | 2030 | 2027 | 99.9 |
| Comparative Example 1-2 | Comparative UDL-2 | 2019 | 1356 | 67.2 |
| Comparative Example 1-3 | Comparative UDL-3 | 2001 | 1996 | 99.8 |
| Comparative Example 1-4 | Comparative UDL-4 | 1994 | 1990 | 99.8 |

As shown in Table 2, in Examples 1-1 to 1-12, where the inventive compositions UDL-1 to -12 for forming a protective film were used, there was hardly any film loss due to the solvent treatment, and it can be observed that films having favorable solvent resistance were obtained. In contrast, in Comparative Example 1-2, where the polymer (R-2), having no terminal groups containing a hydroxy group protected with a tert-butyl group, was used, the film remaining percentage after the PGMEA treatment was about 70%, and sufficient solvent resistance was not exhibited. From these results, it can be seen that a protective film excellent in solvent resistance can be formed from the inventive composition for forming a protective film, containing: a polymer (A1) having a repeating unit represented by the general formula (1A) and having a group represented by the general formula (1B) as a terminal group; and a solvent.

It was also found that further sufficient solvent resistance can be exhibited by the hydroxy groups present in the terminal groups of the polymers (A1-1) to (A1-8) partially reacting with the epoxy groups of (A2-1) and (A2-2). From these results, it can be seen that the combination of the polymer (A1), having a hydroxy group in the terminal group, and the polymer (A2) functions further effectively for the solvent resistance.

### Example 2: Dry Etching Test in N₂/H₂-Based Gas (Examples 2-1 to 2-12, Comparative Examples 2-1 to 2-4)

With regard to the protective films formed as described above and a resist upper layer film formed in the following manner, a dry etching test with an N₂/H₂-based gas was carried out.

A resist upper layer film material (photoresist for ArF) to be used for patterning was prepared by: dissolving a polymer (resin) represented by ArF monolayer resist polymer 1, an acid generator PAG1, and a basic compound amine1 in a solvent containing 0.1% by mass FC-4430 (manufactured by Sumitomo 3M Ltd.) in proportions shown in Table 3; and filtering the mixture through a 0.1-µm filter made of a fluorinated resin.

**[Table 3]**

| Resist upper layer film material | Polymer (parts by mass) | Acid generator (parts by mass) | Basic compound (parts by mass) | Solvent (parts by mass) |
|---|---|---|---|---|
| PR-1 | ArF monolayer resist polymer 1 (100) | PAG1 (6.6) | amine1 (0.8) | PGMEA (2,500) |

The ArF monolayer resist polymer 1, PAG1, and amine1 used are shown below. 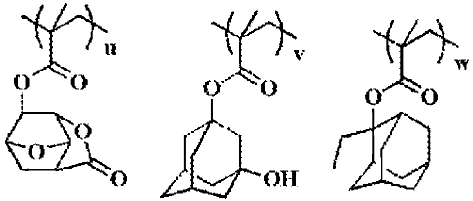 **(ArF monolayer resist polymer 1)**
(u=0.40,v=0,30,w=0.30 Mw7,800)

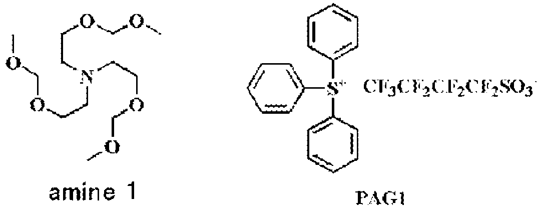

The resist upper layer film material (PR-1) prepared above was applied onto a silicon substrate and baked at 105°C for 60 seconds to form a photoresist film having a film thickness of about 100 nm.

The dry etching test with an N₂/H₂-based gas was carried out under the following conditions.

### Etching conditions

| | |
|---|---|
| Chamber pressure: | 2.7 Pa |
| RF power: | 1,000 W |
| N₂ gas flow rate: | 500 mL/min |
| H₂ gas flow rate: | 30 mL/min |
| Time: | 20 sec |

Table 4 shows the dry etching rate obtained by dividing by the etching time the difference between the film thicknesses of before and after the dry etching measured using an etching apparatus Telius manufactured by Tokyo Electron Limited.

**[Table 4]**

| | Composition for forming protective film | Etching rate (Å/s) |
|---|---|---|
| Example 2-1 | UDL-1 | 40 |
| Example 2-2 | UDL-2 | 39 |
| Example 2-3 | UDL-3 | 37 |
| Example 2-4 | UDL-4 | 35 |
| Example 2-5 | UDL-5 | 36 |
| Example 2-6 | UDL-6 | 37 |
| Example 2-7 | UDL-7 | 38 |
| Example 2-8 | UDL-8 | 39 |
| Example 2-9 | UDL-9 | 43 |
| Example 2-10 | UDL-10 | 37 |
| Example 2-11 | UDL-11 | 36 |
| Example 2-12 | UDL-12 | 38 |
| Comparative Example 2-1 | Comparative UDL-1 | 31 |
| Comparative Example 2-2 | Comparative UDL-3 | 33 |
| Comparative Example 2-3 | Comparative UDL-4 | 32 |
| Comparative Example 2-4 | PR-1 (Resist Upper Layer Film Material) | 24 |

From the above results, it was found that all the protective films formed from the inventive compositions (UDL-1 to -12) for forming a protective film had a higher dry-etching rate than Comparative Examples 2-1 to 2-3 and the resist upper layer film (Comparative Example 2-4). It was found that, compared to existing materials, the present invention can achieve the higher dry-etching rate required by customers. In particular, the present invention is preferable, since residues after the removal of the composition for forming a protective film can be suppressed in a processing process including the removal of the protective film by dry etching after the processing of the substrate.

### Example 3: Filling Property Evaluation (Examples 3-1 to 3-12, Comparative Examples 3-1 to 3-3)

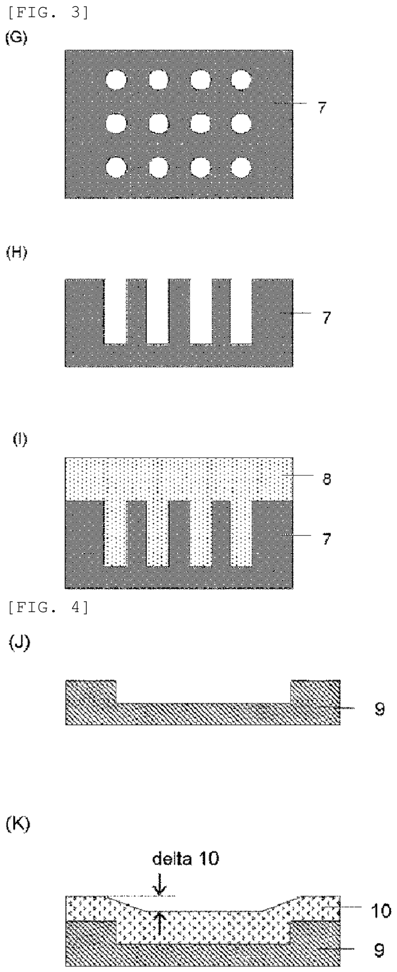

As shown in FIG. 3, each of the compositions (UDL-1 to -12, comparative UDL-1, -3, -4) for forming a protective film was applied respectively onto an SiO₂ wafer substrate having a dense hole pattern (hole diameter: 0.16 µm, hole depth: 0.50 µm, distance between the centers of two adjacent holes: 0.32 µm) and baked by using a hot plate in air at 250°C for 60 seconds to form a protective film 8. The substrate used was a base substrate 7 (SiO₂ wafer substrate) having a dense hole pattern as shown in FIG. 3 (G) (top view) and (H) (sectional view). The sectional profile of each wafer substrate obtained was observed with a scanning electron microscope (SEM) to check whether or not the holes were filled with the protective film without voids (space). The results are shown in Table 5. If a composition for forming a protective film having poor filling property is used, voids occur inside the holes in this evaluation. When a composition for forming a protective film having favorable filling property is used, in this evaluation, the holes are filled with the protective film without voids as shown in FIG. 3 (I).

**[Table 5]**

| | Composition for forming protective film | Presence or Absence of Voids |
|---|---|---|
| Example 3-1 | UDL-1 | Absent |
| Example 3-2 | UDL-2 | Absent |
| Example 3-3 | UDL-3 | Absent |
| Example 3-4 | UDL-4 | Absent |
| Example 3-5 | UDL-5 | Absent |
| Example 3-6 | UDL-6 | Absent |
| Example 3-7 | UDL-7 | Absent |
| Example 3-8 | UDL-8 | Absent |
| Example 3-9 | UDL-9 | Absent |
| Example 3-10 | UDL-10 | Absent |
| Example 3-11 | UDL-11 | Absent |
| Example 3-12 | UDL-12 | Absent |
| Comparative Example 3-1 | Comparative UDL-1 | Absent |
| Comparative Example 3-2 | Comparative UDL-3 | Present |
| Comparative Example 3-3 | Comparative UDL-4 | Present |

As shown in Table 5, in Examples 3-1 to 3-12, where the inventive compositions UDL-1 to -12 for forming a protective film were used, it was possible to fill the hole pattern without generating voids, and it was observed that the compositions had favorable filling property. On the other hand, in Comparative Examples 3-2 and 3-3, voids were generated, and it was observed that filling property was poor. This is because, when polymers having a trihydroxybenzene terminal group and a 1,2-diol terminal group are used, the amount of solvent remaining after application is large, and voids appear when the remaining solvent volatilizes during baking. In the inventive compositions for forming a protective film, the terminal primary alcohol is protected at the time of application, and therefore, there are no 1,2-diol terminal groups. Therefore, the amount of solvent remaining after application is small, so that voids do not occur. From these results, it can be seen that the inventive compositions for forming a protective film have improved filling property because the terminal group is the general formula (1B).

### Example 4: Planarizing Property Evaluation (Examples 4-1 to 4-12, Comparative Examples 4-1 to 4-3)

Each of the compositions (UDL-1 to -12, comparative UDL-1, -3, -4) for forming a protective film was applied respectively onto a base substrate 9 (SiO₂ wafer substrate) having a giant isolated trench pattern (FIG. 4 (J), trench width: 10 µm, trench depth: 0.10 µm), and the coating film thus obtained was baked in air at 250°C for 60 seconds. Then, a step (delta 10 in FIG. 4 (K)) between the trench portion and the non-trench portion of the protective film 10 was observed using an atomic force microscope (AFM) NX10 manufactured by Park Systems. The results are shown in Table 6. In this evaluation, the smaller the step, the better the planarizing property. Note that, in this evaluation, a trench pattern having a depth of 0.10 µm was generally planarized using a composition for forming a protective film at a film thickness of approximately 0.2 µm. This is a severe evaluation condition to evaluate the planarizing property.

**[Table 6]**

| | Composition for forming protective film | Step |
|---|---|---|
| | | (nm) |
| Example 4-1 | UDL-1 | 15 |
| Example 4-2 | UDL-2 | 20 |
| Example 4-3 | UDL-3 | 30 |
| Example 4-4 | UDL-4 | 25 |
| Example 4-5 | UDL-5 | 25 |
| Example 4-6 | UDL-6 | 30 |
| Example 4-7 | UDL-7 | 20 |
| Example 4-8 | UDL-8 | 25 |
| Example 4-9 | UDL-9 | 20 |
| Example 4-10 | UDL-10 | 25 |
| Example 4-11 | UDL-11 | 20 |
| Example 4-12 | UDL-12 | 15 |
| Comparative Example 4-1 | Comparative UDL-1 | 50 |
| Comparative Example 4-2 | Comparative UDL-3 | 75 |
| Comparative Example 4-3 | Comparative UDL-4 | 55 |

As shown in Table 6, regarding the inventive compositions for forming a protective film (Examples 4-1 to 4-12), the steps in the protective film between the trench portion and the non-trench portion were smaller than in Comparative Examples 4-1 to 4-3, confirming that planarization property was excellent. When the polymer (A1), in which the terminal group has a group represented by the general formula (1B), is contained as in the inventive composition for forming a protective film, the primary alcohol of the terminal group of the polymer (A1) is protected during application, and therefore, there are no 1,2-diol terminal groups, and viscosity is decreased. Therefore, since the flatness at the time of application is favorable, the flatness after baking is also favorable. On the other hand, in the compositions used in Comparative Examples 4-1 to 4-3, the terminal group of the compound or polymer contained was a diol or a triol, and therefore, the viscosity of the polymer increased, resulting in degraded flatness compared to the present invention at the time of application. Furthermore, comparing the results of Examples 4-10 to 4-12, in which a high-boiling-point solvent was added, and the results of Examples 4-3, 4-5, and 4-7, in which a high-boiling-point solvent was not added, respectively, it can be seen that in Examples 4-10 to 4-12, flatness was further improved by virtue of the addition of the high-boiling-point solvent.

### Example 5: Alkaline Aqueous Hydrogen Peroxide Resistance Evaluation (Examples 5-1 to 5-12, Comparative Examples 5-1 to 5-4)

Each of the compositions (UDL-1 to -12, comparative UDL-1 to -4) for forming a protective film was respectively applied onto a silicon wafer substrate on which a 300-nm SiO₂ film was formed, and each coating film was baked in air at 250°C for 60 seconds to cure the film to form a protective film (resist underlayer film) having a film thickness of 200 nm. Subsequently, the wafer having the formed protective film was cut to have a width of 2 cm, and this wafer piece was immersed in a 1.0 mass% aqueous hydrogen peroxide containing 0.5 mass% of ammonia at 70°C for 5 minutes. Subsequently, the wafer piece was extracted, rinsed with deionized water, and dried. After drying, it was visually examined whether or not the protective film had been removed from the wafer. If part or all of the protective film is removed and the surface of the silicon wafer is exposed, the protective film subjected to the test is judged to have insufficient resistance to an alkaline aqueous hydrogen peroxide. The evaluation results are shown in Table 7.

**[Table 7]**

| | Composition for forming protective film | 70°C, 5 minutes Examination Results |
|---|---|---|
| Example 5-1 | UDL-1 | No removal |
| Example 5-2 | UDL-2 | No removal |
| Example 5-3 | UDL-3 | No removal |
| Example 5-4 | UDL-4 | No removal |
| Example 5-5 | UDL-5 | No removal |
| Example 5-6 | UDL-6 | No removal |
| Example 5-7 | UDL-7 | No removal |
| Example 5-8 | UDL-8 | No removal |
| Example 5-9 | UDL-9 | No removal |
| Example 5-10 | UDL-10 | No removal |
| Example 5-11 | UDL-11 | No removal |
| Example 5-12 | UDL-12 | No removal |
| Comparative Example 5-1 | Comparative UDL-1 | No removal |
| Comparative Example 5-2 | Comparative UDL-2 | Complete removal |
| Comparative Example 5-3 | Comparative UDL-3 | No removal |
| Comparative Example 5-4 | Comparative UDL-4 | No removal |

As shown in Table 7, in Examples 5-1 to 5-12, where the inventive compositions UDL-1 to -12 for forming a protective film were used, no removal of the protective film was observed in every case. It was found that, when the polymer (A1), in which the terminal group has a group represented by the general formula (1B), is contained as in the inventive composition for forming a protective film, deprotection occurs after baking and the polymer (A1) is provided with a 1,2-diol terminal group, and therefore, adhesiveness to the substrate is enhanced, and excellent resistance to an alkaline aqueous hydrogen peroxide is exhibited. On the other hand, in Comparative Example 5-2, in which it was not possible to achieve solvent resistance, removal of the protective film was observed.

### Example 6: Patterning Test (Examples 6-1 to 6-12, Comparative Examples 6-1 to 6-3)

Each of the compositions (UDL-1 to -12, comparative UDL-1, -3, -4) for forming a protective film was respectively applied onto a silicon wafer substrate on which a 300-nm SiO₂ film was formed, and each coating film was baked in air at 250°C for 60 seconds to cure the film to form a protective film (resist underlayer film) having a film thickness of 200 nm. Then, a CVD-SiON hard mask was formed on the obtained protective film. Subsequently, an organic antireflective coating material (ARC-29A: manufactured by Nissan Chemical Industries, Ltd.) was further applied onto the hard mask, and the coating film was baked at 210°C for 60 seconds to form an organic antireflective coating having a film thickness of 80 nm. Onto the obtained organic antireflective coating, the same monolayer resist for ArF of the resist upper layer film material as that used in Example 2 was applied, and the coating film was baked at 105°C for 60 seconds to form a photoresist film having a film thickness of 100 nm. Subsequently, a liquid immersion top coat material (TC-1) was applied onto the photoresist film and baked at 90°C for 60 seconds to form a liquid immersion top coat having a film thickness of 50 nm.

The liquid immersion top coat material (TC-1) was prepared by: dissolving a top coat polymer (PP1) into organic solvents in proportions shown in Table 8; and filtering the solution through a 0.1-µm filter made of a fluorinated resin.

**[Table 8]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) used for the liquid immersion top coat material (TC-1) is shown below.

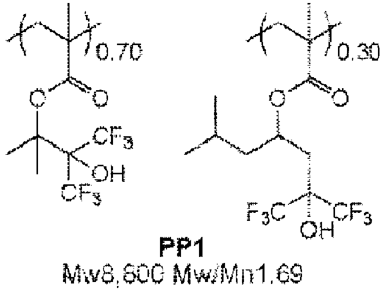

Next, the photoresist film was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked (PEB) at 100°C for 60 seconds, and developed with a 2.38 mass% tetramethylammonium hydroxide (TMAH) aqueous solution for 30 seconds. Thus, a 55 nm 1:1 positive line-and-space pattern was obtained.

Next, the organic antireflective coating and the CVD-SiON hard mask were processed by dry etching with an etching apparatus Telius manufactured by Tokyo Electron Limited while using the resist pattern as a mask to form a hard mask pattern. Subsequently, the protective film was etched while using the obtained hard mask pattern as a mask to form a protective film pattern. The etching conditions were as described below.

Conditions for transferring the resist pattern to the SiON hard mask.

| | |
|---|---|
| Chamber pressure: | 10.0 Pa |
| RF power: | 1,500 W |
| CF₄ gas flow rate: | 75 sccm |
| O₂ gas flow rate: | 15 sccm |
| Time: | 15 sec |

Conditions for transferring the hard mask pattern to the protective film.

| | |
|---|---|
| Chamber pressure: | 2.0 Pa |
| RF power: | 500 W |
| Ar gas flow rate: | 75 sccm |
| O₂ gas flow rate: | 45 sccm |
| Time: | 120 sec |

It was observed whether or not a protective film pattern was formed by the top-down SEM view of the wafer after the etching of the protective film. Subsequently, the wafer was cut to have a width of 2 cm, and this wafer piece was immersed in a 1.0 mass% aqueous hydrogen peroxide containing 0.5 mass% of ammonia at 70°C for 5 minutes. Then, the wafer was rinsed with deionized water and dried, and then observed with an optical microscope to evaluate whether or not the protective film pattern was removed. The evaluation results are shown in Table 9.

**[Table 9]**

| | Composition for forming protective film | Protective Film Pattern | Whether or not pattern was removed |
|---|---|---|---|
| Example 6-1 | UDL-1 | Formed | Not removed |
| Example 6-2 | UDL-2 | Formed | Not removed |
| Example 6-3 | UDL-3 | Formed | Not removed |
| Example 6-4 | UDL-4 | Formed | Not removed |
| Example 6-5 | UDL-5 | Formed | Not removed |
| Example 6-6 | UDL-6 | Formed | Not removed |
| Example 6-7 | UDL-7 | Formed | Not removed |
| Example 6-8 | UDL-8 | Formed | Not removed |
| Example 6-9 | UDL-9 | Formed | Not removed |
| Example 6-10 | UDL-10 | Formed | Not removed |
| Example 6-11 | UDL-11 | Formed | Not removed |
| Example 6-12 | UDL-12 | Formed | Not removed |
| Comparative Example 6-1 | Comparative UDL-1 | Formed | Not removed |
| Comparative Example 6-2 | Comparative UDL-3 | Formed | Not removed |
| Comparative Example 6-3 | Comparative UDL-4 | Formed | Not removed |

As shown in Table 9, from the results of Examples 6-1 to 6-12, where the inventive compositions UDL-1 to - 12 for forming a protective film were used, the resist upper layer film pattern was favorably transferred to the protective film in every case, and it was confirmed that the inventive composition for forming a protective film can be suitably used for fine processing by a multilayer resist method. Furthermore, it was also observed that the formed protective film pattern had favorable resistance to an alkaline aqueous hydrogen peroxide. Accordingly, the inventive composition for forming a protective film and the inventive patterning processes are particularly useful for enabling the production of a semiconductor device by fine processing using a combination of chemical solution etching using an alkaline aqueous hydrogen peroxide or the like and a multilayer resist method.

### Example 7: Patterning Test (Examples 7-1 to 7-12, Comparative Examples 7-1 to 7-3)

Each of the compositions (UDL-1 to -12, Comparative UDL-1, -3, -4) for forming a protective film was respectively applied onto a SiO₂ wafer substrate having a trench pattern (trench width: 10 µm, trench depth 0.10 µm), and each coating film was cured by baking in air at 250°C for 60 seconds to obtain each protective film. On each protective film, coating films were formed in the same manner as in Example 6, and patterning and dry etching were performed to form a protective film pattern. Furthermore, etching of the SiO₂ film was performed while using the obtained protective film pattern as a mask. The etching conditions were as described below.

Conditions for transferring protective film pattern to SiO₂ film.

| | |
|---|---|
| Chamber pressure: | 2.0 Pa |
| RF power: | 2,200 W |
| C₅F₁₂ gas flow rate: | 20 sccm |
| C₂F₆ gas flow rate: | 10 sccm |
| Ar gas flow rate: | 300 sccm |
| O₂ gas flow rate: | 60 sccm |
| Time: | 90 sec |

The pattern cross sections obtained in the SiO₂ films were observed with an electron microscope (S-4700) manufactured by Hitachi, Ltd. The results are shown in Table 10.

**[Table 10]**

| | Composition for forming protective film | Pattern profile after etching for transferring to substrate |
|---|---|---|
| Example 7-1 | UDL-1 | Vertical profile |
| Example 7-2 | UDL-2 | Vertical profile |
| Example 7-3 | UDL-3 | Vertical profile |
| Example 7-4 | UDL-4 | Vertical profile |
| Example 7-5 | UDL-5 | Vertical profile |
| Example 7-6 | UDL-6 | Vertical profile |
| Example 7-7 | UDL-7 | Vertical profile |
| Example 7-8 | UDL-8 | Vertical profile |
| Example 7-9 | UDL-9 | Vertical profile |
| Example 7-10 | UDL-10 | Vertical profile |
| Example 7-11 | UDL-11 | Vertical profile |
| Example 7-12 | UDL-12 | Vertical profile |
| Comparative Example 7-1 | Comparative UDL-1 | Vertical profile |
| Comparative Example 7-2 | Comparative UDL-3 | Vertical profile |
| Comparative Example 7-3 | Comparative UDL-4 | Vertical profile |

As shown in Table 10, from the results of Examples 7-1 to 7-12, where the inventive compositions UDL-1 to - 12 for forming a protective film were used, the resist upper layer film pattern was favorably transferred to the final substrate in each ease, thus confirming that the inventive compositions for forming a protective film can be suitably used in fine processing according to the multilayer resist method.

From the above, it can be seen that the inventive composition for forming a protective film has excellent resistance to an alkaline aqueous hydrogen peroxide and also has high filling and planarizing properties and excellent dry-etching properties, and therefore, is extremely useful as a composition for forming a protective film used in a multilayer resist method. In addition, it can be seen that, according to the inventive patterning processes using the inventive composition for forming a protective film, a fine pattern can be formed with high precision even when the body to be processed is a stepped substrate, and therefore, the inventive patterning processes can be used suitably for a multilayer resist process for fine patterning in the production of a semiconductor device. In particular, the inventive patterning process is also applicable to a multilayer resist process including wet etching processing, and is industrially extremely useful.

The present invention includes the following embodiments.
[1] A composition for forming a protective film against an alkaline aqueous hydrogen peroxide, the composition comprising:
   (A1) a polymer having a repeating unit represented by the following general formula (1A) and having a group represented by the following general formula (1B) as a terminal group; and
   (B) an organic solvent, 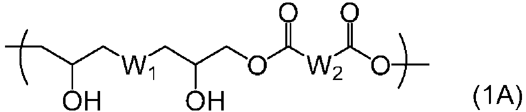
   wherein W₁ represents a sulfinyl group, a sulfonyl group, an ether group, or a divalent organic group having 2 to 50 carbon atoms, and W₂ represents a divalent organic group having 2 to 50 carbon atoms. 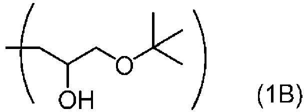
[2] The composition for forming a protective film according to [1], wherein the W₁ in the general formula (1A) represents a divalent heterocyclic group having 3 to 10 carbon atoms.
[3] The composition for forming a protective film according to [1] or [2], wherein the W₂ in the general formula (1A) has an alicyclic structure.
[4] The composition for forming a protective film according to any one of [1] to [3], wherein the polymer (A1) has a weight-average molecular weight of 1000 to 30000.
[5] The composition for forming a protective film according to any one of [1] to [4], further comprising
   (A2) an additional polymer including one or more kinds of a repeating unit represented by the following general formula (1C), 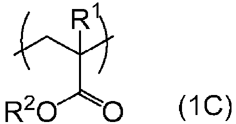
   wherein R¹ represents a hydrogen atom or a methyl group, and R² represents a group selected from the group consisting of the following formulae (1-1) to (1-3), 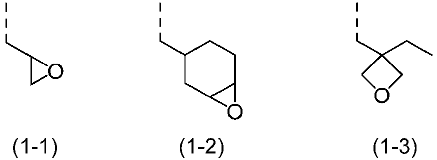
   wherein a broken line represents an attachment point.
[6] The composition for forming a protective film according to [5], wherein the additional polymer (A2) further includes one or more kinds of a repeating unit represented by the following general formula (1D), 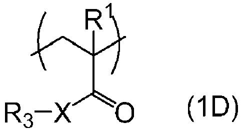 wherein R¹ represents a hydrogen atom or a methyl group, X represents -O- or -NH-, and R₃ represents an organic group having 2 to 10 carbon atoms and optionally containing an oxygen atom.
[7] The composition for forming a protective film according to [5] or [6], wherein the additional polymer (A2) further includes one or more kinds of a repeating unit represented by the following general formula (1E), 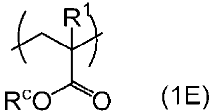 wherein R¹ represents a hydrogen atom or a methyl group, and R^{c} represents a monovalent group having an alicyclic structure and having 3 to 20 carbon atoms.
[8] The composition for forming a protective film according to any one of [5] to [7], wherein the additional polymer (A2) has a weight-average molecular weight of 1,000 to 20,000.
[9] The composition for forming a protective film according to any one of [1] to [8], wherein the organic solvent (B) is a mixture of one or more kinds of organic solvent having a boiling point of lower than 180°C and one or more kinds of organic solvent having a boiling point of 180°C or higher.
[10] The composition for forming a protective film according to any one of [1] to [9], further comprising one or more kinds selected from the group consisting of:
   (C) an acid generator;
   (D) a surfactant;
   (E) a crosslinking agent;
   (F) a plasticizer; and
   (G) a colorant.
[11] The composition for forming a protective film according to any one of [1] to [10], wherein the composition for forming a protective film provides a protective film that exhibits resistance to an ammonia-containing aqueous hydrogen peroxide.
[12] The composition for forming a protective film according to [11], wherein when a silicon substrate on which the protective film has been formed is immersed in a 1.0 mass% aqueous hydrogen peroxide containing ammonia at a concentration of 0.5 mass% at 70°C for 5 minutes, no removal of the protective film is observed.
[13] A substrate for manufacturing a semiconductor device, comprising:
   a substrate; and
   a protective film which is a cured product of the composition for forming a protective film according to any one of [1] to [12], formed on the substrate.
[14] A method for forming a protective film to be used in a process of manufacturing a semiconductor device, the method comprising:
   spin-coating a substrate to be processed with the composition for forming a protective film according to any one of [1] to [12] to obtain a coating film; and
   curing the coating film by heating at a temperature of 100°C or higher and 600°C or lower for 10 to 600 seconds to obtain a cured film.
[15] The method for forming a protective film according to [14], wherein the substrate to be processed has a structure or step having a height of 30 nm or more.
[16] A patterning process for forming a pattern in a substrate to be processed, comprising the steps of:
   (I-1) forming a protective film on a substrate to be processed by using the composition for forming a protective film according to any one of [1] to [12];
   (I-2) forming a resist upper layer film on the protective film by using a photoresist material;
   (I-3) forming a circuit pattern in the resist upper layer film; and
   (I-4) transferring the pattern to the protective film by etching while using the resist upper layer film having the formed pattern as a mask.
[17] A patterning process for forming a pattern in a substrate to be processed, comprising the steps of:
   (II-1) forming a protective film on a substrate to be processed by using the composition for forming a protective film according to any one of [1] to [12];
   (II-2) forming a silicon-containing resist middle layer film on the protective film by using a silicon-containing resist middle layer film material;
   (II-3) forming a resist upper layer film on the silicon-containing resist middle layer film by using a photoresist composition;
   (II-4) forming a circuit pattern in the resist upper layer film;
   (II-5) transferring the pattern to the silicon-containing resist middle layer film by etching while using the resist upper layer film having the formed pattern as a mask;
   (II-6) transferring the pattern to the protective film by etching while using the silicon-containing resist middle layer film having the transferred pattern as a mask; and
   (II-7) forming the pattern in the substrate to be processed while using the protective film having the transferred pattern as a mask.
[18] A patterning process for forming a pattern in a substrate to be processed, comprising the steps of:
   (III-1) forming a protective film on a substrate to be processed by using the composition for forming a protective film according to any one of [1] to [12];
   (III-2) forming an inorganic hard mask selected from the group consisting of a silicon oxide film, a silicon nitride film, a silicon oxynitride film, a titanium oxide film, and a titanium nitride film on the protective film;
   (III-3) forming an organic antireflective coating on the inorganic hard mask;
   (III-4) forming a resist upper layer film on the organic antireflective coating by using a photoresist composition, so that a 4-layered film structure is constructed, and forming a circuit pattern in the resist upper layer film;
   (III-5) transferring the pattern to the organic antireflective coating and the inorganic hard mask by etching while using the resist upper layer film having the formed pattern as a mask;
   (III-6) transferring the pattern to the protective film by etching while using the inorganic hard mask having the transferred pattern as a mask; and
   (III-7) forming the pattern in the substrate to be processed while using the protective film having the transferred pattern as a mask.
[19] The patterning process according to [18], wherein the inorganic hard mask is formed by a CVD method or an ALD method.
[20] The patterning process according to [17], further comprising, after the step (II-6), a step of removing the silicon-containing resist middle layer film having the transferred pattern by wet etching using an alkaline aqueous hydrogen peroxide.
[21] The patterning process according to any one of [16] to [18], further comprising, after the step (I-4), the step (II-7), or the step (III-7), a step of transferring the pattern to the substrate to be processed by wet etching using an alkaline aqueous hydrogen peroxide while using the protective film having the transferred pattern as a mask.
[22] The patterning process according to any one of [16] to [18], further comprising, after the step (I-4), the step (II-7), or the step (III-7), a step of pattern-processing the substrate to be processed by implanting ions while using the protective film having the transferred pattern as a mask.
[23] The patterning process according to any one of [17] to [19], further comprising the steps of:
   after the step (II-7) or the step (III-7), pattern-processing the substrate to be processed by implanting ions while using the protective film having the transferred pattern as a mask; and
   after the step of pattern-processing the substrate to be processed by implanting ions, removing the silicon-containing resist middle layer film having the transferred pattern by wet etching using an alkaline aqueous hydrogen peroxide.
[24] The patterning process according to any one of [16] to [18], wherein the circuit pattern is formed by a lithography using light with a wavelength of 10 nm or more to 300 nm or less, a direct drawing with electron beam, nanoimprinting, or a combination thereof.
[25] The patterning process according to any one of [16] to [18], wherein the circuit pattern is developed by alkali development or with an organic solvent.
[26] The patterning process according to any one of [16] to [18], wherein the substrate to be processed is a semiconductor device substrate or the semiconductor device substrate coated with any of a metal film, a metal carbide film, a metal oxide film, a metal nitride film, a metal oxycarbide film, and a metal oxynitride film.
[27] The patterning process according to [26], wherein the substrate to be processed contains silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a protective film against an alkaline aqueous hydrogen peroxide, the composition comprising:
(A1) a polymer having a repeating unit represented by the following general formula (1A) and having a group represented by the following general formula (1B) as a terminal group; and
(B) an organic solvent, 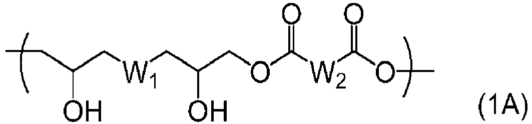
wherein W₁ represents a sulfinyl group, a sulfonyl group, an ether group, or a divalent organic group having 2 to 50 carbon atoms, and W₂ represents a divalent organic group having 2 to 50 carbon atoms.

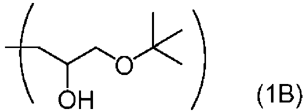

2. The composition for forming a protective film according to claim 1, wherein the W₁ in the general formula (1A) represents a divalent heterocyclic group having 3 to 10 carbon atoms.

3. The composition for forming a protective film according to claim 1 or 2, wherein the W₂ in the general formula (1A) has an alicyclic structure.

4. The composition for forming a protective film according to any one of claims 1 to 3, wherein the polymer (A1) has a weight-average molecular weight of 1000 to 30000.

5. The composition for forming a protective film according to any one of claims 1 to 4, further comprising
(A2) an additional polymer including one or more kinds of a repeating unit represented by the following general formula (1C), 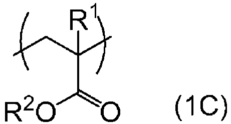
wherein R¹ represents a hydrogen atom or a methyl group, and R² represents a group selected from the group consisting of the following formulae (1-1) to (1-3), 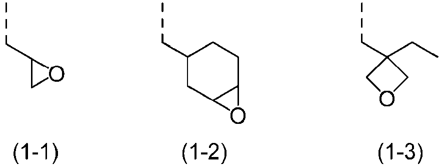
wherein a broken line represents an attachment point,
preferably wherein the additional polymer (A2) further includes one or more kinds of a repeating unit represented by the following general formula (1D), 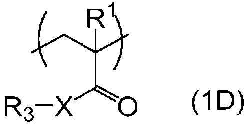
wherein R¹ represents a hydrogen atom or a methyl group, X represents -O- or -NH-, and R₃ represents an organic group having 2 to 10 carbon atoms and optionally containing an oxygen atom; and/or
preferably wherein the additional polymer (A2) further includes one or more kinds of a repeating unit represented by the following general formula (1E), 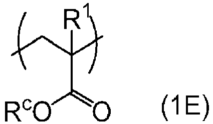
wherein R¹ represents a hydrogen atom or a methyl group, and R^{c} represents a monovalent group having an alicyclic structure and having 3 to 20 carbon atoms, and/or
preferably wherein the additional polymer (A2) has a weight-average molecular weight of 1,000 to 20,000.

6. The composition for forming a protective film according to any one of claims 1 to 5, wherein the organic solvent (B) is a mixture of one or more kinds of organic solvent having a boiling point of lower than 180°C and one or more kinds of organic solvent having a boiling point of 180°C or higher.

7. The composition for forming a protective film according to any one of claims 1 to 6, further comprising one or more kinds selected from the group consisting of:
(C) an acid generator;
(D) a surfactant;
(E) a crosslinking agent;
(F) a plasticizer; and
(G) a colorant.

8. The composition for forming a protective film according to any one of claims 1 to 7, wherein the composition for forming a protective film provides a protective film that exhibits resistance to an ammonia-containing aqueous hydrogen peroxide,
preferably wherein when a silicon substrate on which the protective film has been formed is immersed in a 1.0 mass% aqueous hydrogen peroxide containing ammonia at a concentration of 0.5 mass% at 70°C for 5 minutes, no removal of the protective film is observed.

9. A substrate for manufacturing a semiconductor device, comprising:
a substrate; and
a protective film which is a cured product of the composition for forming a protective film according to any one of claims 1 to 8, formed on the substrate.

10. A method for forming a protective film to be used in a process of manufacturing a semiconductor device, the method comprising:
spin-coating a substrate to be processed with the composition for forming a protective film according to any one of claims 1 to 8 to obtain a coating film; and
curing the coating film by heating at a temperature of 100°C or higher and 600°C or lower for 10 to 600 seconds to obtain a cured film,
preferably wherein the substrate to be processed has a structure or step having a height of 30 nm or more.

11. A patterning process for forming a pattern in a substrate to be processed, comprising the steps of:
(I-1) forming a protective film on a substrate to be processed by using the composition for forming a protective film according to any one of claims 1 to 8;
(I-2) forming a resist upper layer film on the protective film by using a photoresist material;
(I-3) forming a circuit pattern in the resist upper layer film; and
(I-4) transferring the pattern to the protective film by etching while using the resist upper layer film having the formed pattern as a mask, preferably wherein the patterning process further comprises, after the step (I-4), a step of transferring the pattern to the substrate to be processed by wet etching using an alkaline aqueous hydrogen peroxide while using the protective film having the transferred pattern as a mask, or a step of pattern-processing the substrate to be processed by implanting ions while using the protective film having the transferred pattern as a mask, or
a patterning process for forming a pattern in a substrate to be processed, comprising the steps of:
(II-1) forming a protective film on a substrate to be processed by using the composition for forming a protective film according to any one of claims 1 to 8;
(II-2) forming a silicon-containing resist middle layer film on the protective film by using a silicon-containing resist middle layer film material;
(II-3) forming a resist upper layer film on the silicon-containing resist middle layer film by using a photoresist composition;
(II-4) forming a circuit pattern in the resist upper layer film;
(II-5) transferring the pattern to the silicon-containing resist middle layer film by etching while using the resist upper layer film having the formed pattern as a mask;
(II-6) transferring the pattern to the protective film by etching while using the silicon-containing resist middle layer film having the transferred pattern as a mask; and
(II-7) forming the pattern in the substrate to be processed while using the protective film having the transferred pattern as a mask, preferably wherein the patterning process further comprises, after the step (II-6), a step of removing the silicon-containing resist middle layer film having the transferred pattern by wet etching using an alkaline aqueous hydrogen peroxide, and/or preferably wherein the patterning process further comprises, after the step (II-7), pattern-processing the substrate to be processed by implanting ions while using the protective film having the transferred pattern as a mask; and
after the step of pattern-processing the substrate to be processed by implanting ions, removing the silicon-containing resist middle layer film having the transferred pattern by wet etching using an alkaline aqueous hydrogen peroxide. or
a patterning process for forming a pattern in a substrate to be processed, comprising the steps of:
(III-1) forming a protective film on a substrate to be processed by using the composition for forming a protective film according to any one of claims 1 to 8;
(III-2) forming an inorganic hard mask selected from the group consisting of a silicon oxide film, a silicon nitride film, a silicon oxynitride film, a titanium oxide film, and a titanium nitride film on the protective film;
(III-3) forming an organic antireflective coating on the inorganic hard mask;
(III-4) forming a resist upper layer film on the organic antireflective coating by using a photoresist composition, so that a 4-layered film structure is constructed, and forming a circuit pattern in the resist upper layer film;
(III-5) transferring the pattern to the organic antireflective coating and the inorganic hard mask by etching while using the resist upper layer film having the formed pattern as a mask;
(III-6) transferring the pattern to the protective film by etching while using the inorganic hard mask having the transferred pattern as a mask; and
(III-7) forming the pattern in the substrate to be processed while using the protective film having the transferred pattern as a mask, preferably wherein the inorganic hard mask is formed by a CVD method or an ALD method.

12. The patterning process according to claim 11, wherein the circuit pattern is formed by a lithography using light with a wavelength of 10 nm or more to 300 nm or less, a direct drawing with electron beam, nanoimprinting, or a combination thereof.

13. The patterning process according to claim 11 or 12, wherein the circuit pattern is developed by alkali development or with an organic solvent.

14. The patterning process according to any one of claims 11 to 13, wherein the substrate to be processed is a semiconductor device substrate or the semiconductor device substrate coated with any of a metal film, a metal carbide film, a metal oxide film, a metal nitride film, a metal oxycarbide film, and a metal oxynitride film.

15. The patterning process according to claim 14, wherein the substrate to be processed contains silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.
